(19) Europäisches Patentamt / European Patent Office / Office européen des brevets

(11) EP 4 310 930 A1

(12) **EUROPEAN PATENT APPLICATION**
published in accordance with Art. 153(4) EPC

(43) Date of publication:
**24.01.2024 Bulletin 2024/04**

(21) Application number: **22771349.2**

(22) Date of filing: **14.03.2022**

(51) International Patent Classification (IPC):
***H01L 51/50** (2006.01)* ***C09K 11/06** (2006.01)*
***H05B 33/10** (2006.01)*

(52) Cooperative Patent Classification (CPC):
**C09K 11/06; H05B 33/10**

(86) International application number:
**PCT/JP2022/011169**

(87) International publication number:
**WO 2022/196603 (22.09.2022 Gazette 2022/38)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **16.03.2021 JP 2021042437**

(71) Applicant: **Kyulux, Inc.**
**Fukuoka-shi, Fukuoka 819-0388 (JP)**

(72) Inventor: **KAKIZOE, Hayato**
**Fukuoka-shi, Fukuoka 819-0388 (JP)**

(74) Representative: **Zimmermann & Partner Patentanwälte mbB**
**Postfach 330 920**
**80069 München (DE)**

# (54) COMPOSITION, USE OF SAID COMPOSITION AS LIGHT-EMITTING COMPOSITION, FILM, USE OF SAID FILM AS LIGHT-EMITTING FILM, ORGANIC ELECTROLUMINESCNET ELEMENT, METHOD FOR DESIGNING COMPOSITION, AND PROGRAM FOR IMPLEMENTING SAID DESIGN METHOD

(57) A TAF-type organic light emitting device having a high efficiency and a high color purity, which contains a composition containing a first organic compound, a second organic compound of a delayed fluorescent material and a third organic compound of a fluorescent material satisfying the following formulae. $E_{S1}$ represents a lowest excited singlet energy $\lambda^{E}_{EM}$ represents an emission wavelength on the short wavelength side, $\lambda^{P}_{AB}$ represents a wavelength of the peak top on the longest wavelength side of an absorption spectrum, $\lambda^{P}_{BM}$ represents a wavelength of the peak top of an emission spectrum. $E_{S1}(1) > E_{S1}(2) > E_{S1}(3)$; $\lambda^{E}_{EM}(2) < \lambda^{P}_{AB}(3)$ -10 nm; $\lambda^{P}_{EM}(3) < \lambda^{P}_{EM}(2)$; $\lambda^{P}_{EM}(3) < 480$ nm

EP 4 310 930 A1

## Description

Technical Field

The present invention relates to a composition capable of emission by a TAF (TADF-assisted fluorescent) mechanism, use of the composition as a light emitting composition, an organic electroluminescent device using the composition, and to a design method for the composition and a program for implementing the design method.

Background Art

As an organic light emitting device utilizing a delayed fluorescent material, there has been developed a TAF (TADF-assisted fluorescence)-type organic light emitting device that uses a delayed fluorescent material as an assist dopant combined with a fluorescent material of a light emitting material. The TAF-type organic light emitting device exhibits a higher light emission efficiency as compared with an ordinary fluorescence-type organic light emitting device, because of the following reason.

Specifically, recombination of an electron and a hole in the light emitting layer of an organic light emitting device generates an excited singlet state and an excited triplet state with a probability of 25%/75% according to the spin statistics law. Here, in an ordinary fluorescent material, the excited triplet state radiates heat as non-radiative deactivation, and therefore only the excited singlet energy equivalent to 25% is utilized for light emission, and there is a theoretical limit to the emission efficiency. On the other hand, a delayed fluorescent material is an organic compound that undergoes reverse intersystem crossing from the excited triplet state to the excited singlet state. Consequently, when a delayed fluorescent material and a fluorescent material are combined and used in a light emitting layer, the excited triplet energy is converted into an excited singlet energy in the delayed fluorescent material and moves to the fluorescent material by Foerster transfer, and the fluorescent material thus having received the energy also undergoes radiative deactivation from the excited singlet state thereby to emit light. Through the mechanism, in the TAF-type organic light emitting device, the excited triplet energy generated by direct excitation is also utilized for fluorescence emission along with the excited singlet energy generated by direct excitation, and therefore the device exhibits a high emission efficiency.

With that, recently, by further devising a combination of a delayed fluorescent material and a light emitting material, a more excellent TAF-type organic light emitting device has been proposed.

For example, PTL 1 describes that a TAF-type organic light emitting device using a specific BN polycyclic aromatic compound as a light emitting material and using a cyanobenzene substituted with four substituted or unsubstituted carbazol-9-yl groups (provided that all four are not the same) as a delayed fluorescent material exhibits a high light emission efficiency.

NPL 1 describes that, in a TAF-type organic light emitting device using general-purpose fluorescent materials of blue, green, yellow and red combined with a specific delayed fluorescent material, energy transfer from the delayed fluorescent material to the fluorescent material occurs efficiently, and therefore the device exhibits a high light emission efficiency.

NPL 2 describes that, in a TAF-type organic light emitting device using a specific yellow fluorescent material combined with a dicyano benzene substituted with four 3,6-dimethylcarbazol-9-yl groups as a delayed fluorescent material, Foerster transfer of the excited singlet energy occurs efficiently to improve the operational stability.

Citation List

Patent Literature

PTL 1: WO2020/039930A

Non-Patent Literature

NPL 1: Nature Commun. DOI: 10.1038/ncomms5016
NPL 2: Sci. Rep. DOI: 10.1038/srep08429

Summary of Invention

Technical Problem

As described above, regarding the TAF-type organic light emitting device, there have heretofore been proposed some combinations of a delayed fluorescent material having a specific chemical structure and a light emitting material having a specific chemical structure, and devices employing a specific combination of a delayed fluorescent material and a light emitting material have been investigated for the light emission efficiency and the operational stability thereof. However, in studies and developments of conventional TAF-type organic light emitting devices, the conditions to be an index for combination of the delayed fluorescent material and the light emitting material therein are not generalized, and it has been extremely difficult to find out a combination capable of bringing about light emission with an extremely high efficiency and a high color purity from the proposed range of a delayed fluorescent material and a light emitting material.
Given the situation, in order to solve the prior-art problems as above, and in order to provide a TAF-type organic light emitting device that exhibits light emission with an extremely high efficiency and a high color purity, the present inventors have made further investigations for the purpose of generalizing the conditions that a delayed fluorescent material and a light emitting material are to satisfy.

Solution to Problem

As a result of having advanced assiduous studies for solving the above-mentioned problems, the present inventors have found that, by adding to the material system, a first organic compound having a higher lowest excited singlet energy than a delayed fluorescent material and a fluorescent material, and in addition thereto, by further defining the conditions of the lowest excited singlet energy, the absorption spectrum and the emission spectrum of the delayed fluorescent material and the fluorescent material, a TAF-type organic light emitting device capable of exhibiting light emission at a high efficiency and a high color purity can be realized. The present invention has been proposed on the basis of such findings, and specifically has the following constitution.
[1] A composition containing a first organic compound, a second organic compound of a delayed fluorescent material and a third organic compound of a fluorescent material satisfying the following requirements (a) to (d).

$$\text{Requirement (a)} \qquad E_{S1}(1) > E_{S1}(2) > E_{S1}(3)$$

$$\text{Requirement (b)} \qquad \lambda^{E}_{EM}(2) < \lambda^{P}_{AB}(3) - 10\ \text{nm}$$

$$\text{Requirement (c)} \qquad \lambda^{P}_{EM}(3) < \lambda^{P}_{EM}(2)$$

$$\text{Requirement (d)} \qquad \lambda^{P}_{EM}(3) < 480\ \text{nm}$$

wherein:

$E_{S1}(1)$ represents the lowest excited singlet energy of the first organic compound,
$E_{S1}(2)$ represents the lowest excited singlet energy of the second organic compound,
$E_{S1}(3)$ represents the lowest excited singlet energy of the third organic compound,
$\lambda^{E}_{EM}(2)$ represents the emission wavelength (unit nm) on the short wavelength side of the second organic compound,
$\lambda^{P}_{AB}(3)$ represents the wavelength (unit nm) of the peak top on the longest wavelength side of the absorption spectrum of the third organic compound,
$\lambda^{P}_{EM}(2)$ represents the wavelength of the peak top of the emission spectrum of the second organic compound,
$\lambda^{P}_{EM}(3)$ represents the wavelength of the peak top of the emission spectrum of the third organic compound.

[2] The composition according to [1], satisfying the following requirement (e).

$$\text{Requirement (e)} \qquad FW_{0.3M} < 40 \text{ nm}$$

wherein $FW_{0.3M}$ represents the spectral width in which the relative intensity to the emission peak of the emission spectrum of the composition is 30%.

[3] The composition according to [2], satisfying the following requirement (e1).

$$\text{Requirement (e1)} \qquad FW_{0.3M} < 32 \text{ nm}$$

[4] The composition according to any one of [1] to [3], satisfying the following requirements (f) and (g).

$$\text{Requirement (f)} \qquad LUMO(2) \leq LUMO(3)$$

$$\text{Requirement (g)} \qquad HOMO(2) \leq HOMO(3)$$

wherein LUMO(2) represents the LUMO energy of the second organic compound, LUMO(3) represents the LUMO energy of the third organic compound, HOMO(2) represents the HOMO energy of the second organic compound, HOMO(3) represents the HOMO energy of the third organic compound.

[5] The composition according to any one of [1] to [4], satisfying the following requirement (h).

$$\text{Requirement (h)} \qquad R_0(2\text{-}3) > 6.5 \text{ nm}$$

wherein $R_0$(2-3) represents the Foerster radius between the second organic compound and the third organic compound.

[6] The composition according to any one of [1] to [5], satisfying the following requirement (i).

$$\text{Requirement (i)} \qquad r(2\text{-}3) < 3.91 \text{ nm}$$

wherein r(2-3) represents the intermolecular distance between the second organic compound and the third organic compound.

[7] The composition according to any one of [1] to [6], satisfying the following requirement (j).

$$\text{Requirement (j)} \qquad k_{FRET}(2\text{-}3) > 1.5\times10^9 \text{ s}^{-1}$$

wherein $k_{FRET}$(2-3) represents the Foerster energy transfer speed constant between the second organic compound and the third organic compound.

[8] The composition according to any one of [1] to [4], satisfying the following requirements (h1)), (i1) and (j1).

$$\text{Requirement (h1)} \qquad R_0(2\text{-}3) \geq 7.3 \text{ nm}$$

$$\text{Requirement (i1)} \qquad r(2\text{-}3) \leq 3.71 \text{ nm}$$

$$\text{Requirement (j1)} \qquad k_{FRET}(2\text{-}3) \geq 6.1\times10^9 \text{ s}^{-1}$$

wherein $R_0$(2-3) represents the Foerster radius between the second organic compound and the third organic compound, r(2-3) represents the intermolecular distance between the second organic compound and the third organic compound, $k_{FRET}$(2-3) represents the Foerster energy transfer speed constant between the second organic compound and the third organic compound.

[9] The composition according to any one of [1] to [8], wherein the second organic compound has a structure

represented by the following general formula (1).

General Formula (1)

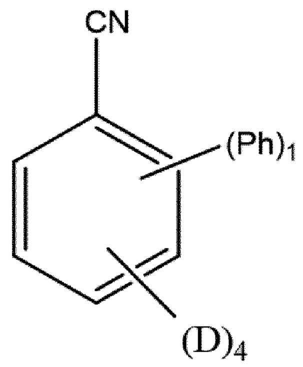

wherein D represents a substituted or unsubstituted carbazol-9-yl group, Ph represents a phenyl group optionally substituted with at least one group selected from the group consisting of an alkyl group, an aryl group and a group of these groups linking together.

[10] The composition according to [9], wherein the second organic compound has a structure represented by the following general formula (1a).

General Formula (1a)

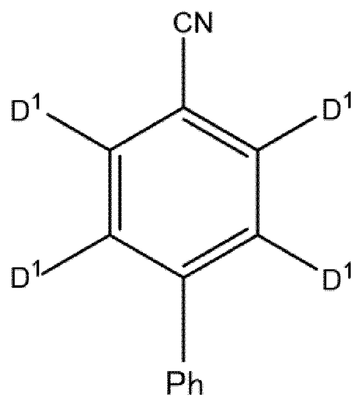

wherein $D^1$ represents a substituted or unsubstituted carbazol-9-yl group, Ph represents a phenyl group optionally substituted with at least one group selected from the group consisting of an alkyl group, an aryl group and a group of these groups linking together.

[11] The composition according to any one of [1] to [8], wherein the second organic compound has a structure represented by the following general formula (2).

General Formula (2)

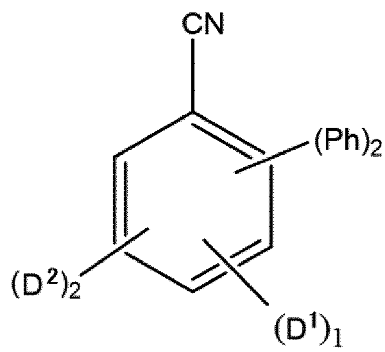

wherein $D^1$ represents a substituted or unsubstituted carbazol-9-yl group, $D^2$ represents a substituted or unsubstituted carbazol-9-yl group that differs from $D^1$, two Ph's each independently represent a phenyl group optionally substituted with at least one group selected from the group consisting of an alkyl group, an aryl group and a group of these groups linking together.

[12] The composition according to [11], wherein the second organic compound has a structure represented by the following general formula (2a).

General Formula (2a)

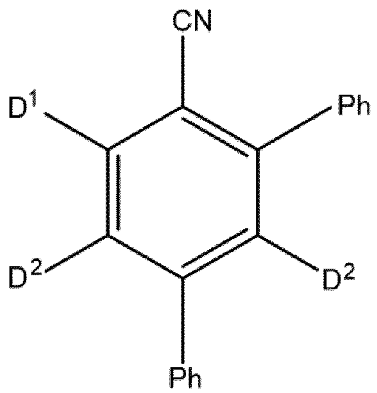

wherein $D^1$ represents a substituted or unsubstituted carbazol-9-yl group, $D^2$ represents a substituted or unsubstituted carbazol-9-yl group that differs from $D^1$, two Ph's each independently represent a phenyl group optionally substituted with at least one group selected from the group consisting of an alkyl group, an aryl group and a group of these groups linking together.

[13] The composition according to any one of [9] to [12], wherein D, $D^1$ and $D^2$ each independently have a structure represented by any of the following D1 to D37.

D1

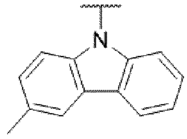

D2

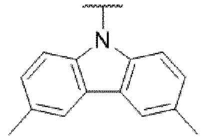

D3

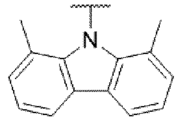

D4

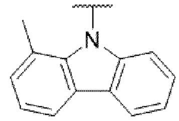

D5
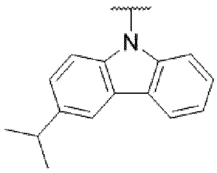
D6
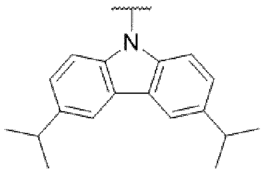
D7
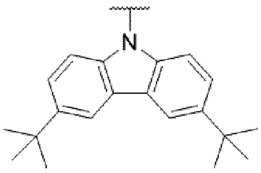
D8
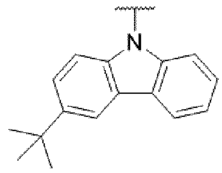

D9
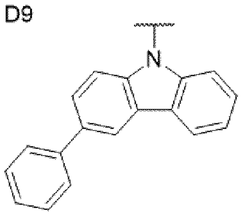
D10
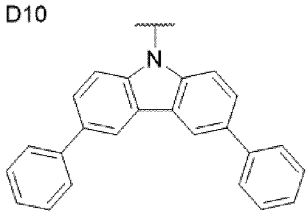
D11
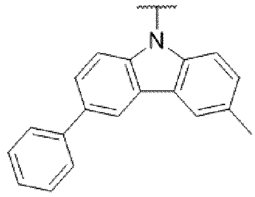
D12
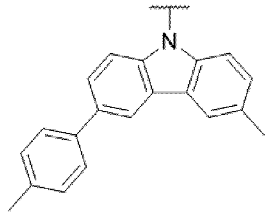

D13
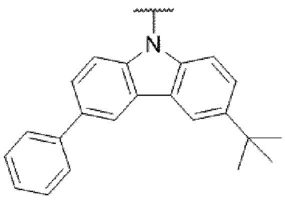
D14
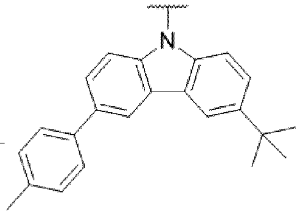
D15
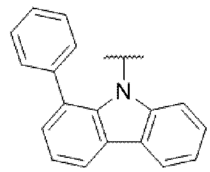
D16
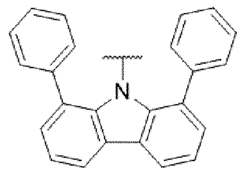

D17
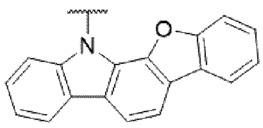
D18
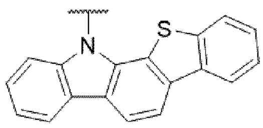
D19
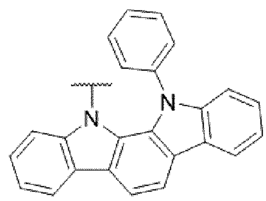
D20
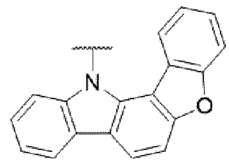

D21
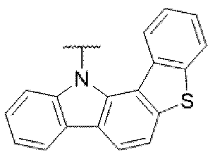
D22
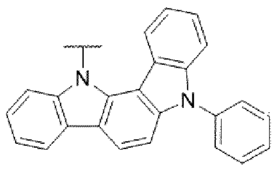
D23
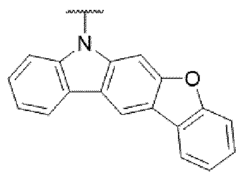
D24
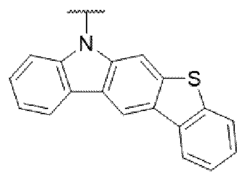

D25
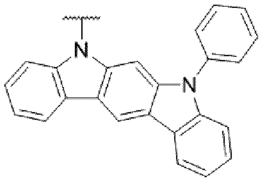
D26
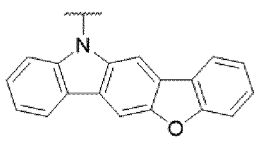
D27
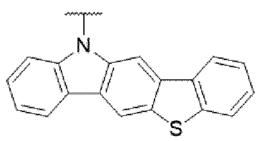
D28
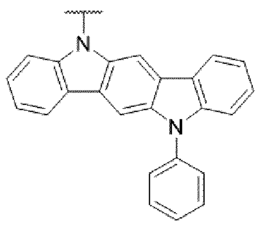

D29
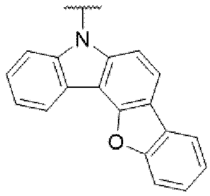
D30
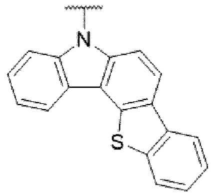
D31
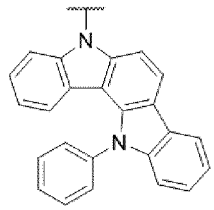
D32
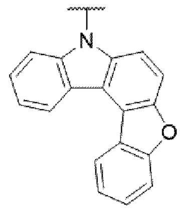

D33
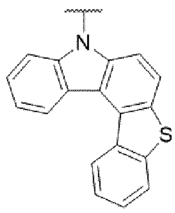
D34
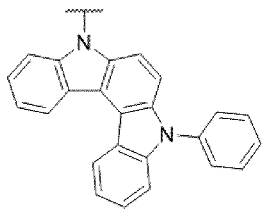
D35
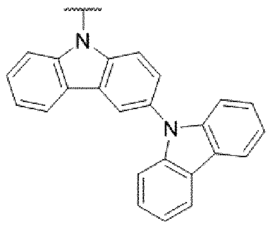
D36
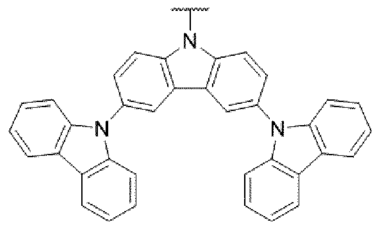

D37
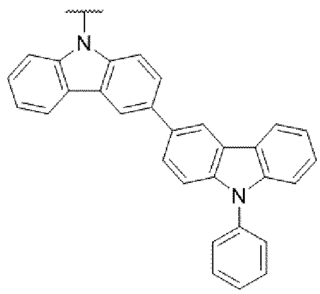

[14] Use of the composition of any one of [1] to [13] as a light emitting composition.

[15] A film containing a light emitting composition of the composition of any one of [1] to [13].

[16] Use of the film of [15] as a light emitting film.

[17] An organic electroluminescent device having an anode, a cathode, and at least one organic layer containing a light emitting layer between the anode and the cathode, wherein the light emitting layer contains the composition of any one of [1] to [13], and the maximum component of light emission from the device is fluorescence from the third organic compound.

[18] The organic electroluminescent device according to [17], which is a top-emission type.

[19] A design method for a composition containing a first organic compound, a second organic compound and a third organic compound, wherein the first organic compound, the second organic compound of a delayed fluorescent material and the third organic compound of a fluorescent material are selected so as to satisfy the requirements (a) to (d).

[20] The design method for a composition according to [19], wherein the compounds are selected so as to additionally satisfy the requirements (f) and (g).

[21] The design method for a composition according to [19] or [20], wherein the compounds are selected so as to additionally satisfy the requirement (h).

$$\text{Requirement (h)} \qquad R_0(2\text{-}3) > 6.5\ \text{nm}$$

wherein $R_0(2\text{-}3)$ represents the Foerster radius between the second organic compound and the third organic compound.

[22] The design method for a composition according to any one of [19] to [21], wherein the compounds are selected so as to additionally satisfy the requirement (i).

[23] The design method for a composition according to any one of [19] to [22], wherein the compounds are selected

so as to additionally satisfy the requirement (j).
[24] The design method for a composition according to [19], wherein the compounds are selected so as to additionally satisfy the requirements (h1), (i1) and (j 1).
[25] A program for implementing the design method for a composition of any one of [19] to [24].

Advantageous Effects of Invention

The composition of the present invention contains three kinds of organic compounds satisfying predetermined requirements, and therefore owing to the TAF mechanism thereof, exhibits high-efficiency high-purity color emission, and can provide a high color purity especially within a wavelength range of less than 480 nm. Consequently, the composition of the present invention has significant usefulness as a light emitting composition. Using the composition of the present invention, a TAF-type organic light emitting device capable of exhibiting light emission at a high color purity and a high efficiency can be readily realized.

Brief Description of Drawings

[Fig. 1] This is a flow chart showing an example of a program implementing protocol.
[Fig. 2] This shows emission spectra of a thin film of a composition 1 composed of a compound H1, a compound DF1 and a compound F1, a thin film of a composition 2 composed of the compound H1, a compound DF2 and the compound F1, and a thin film of a comparative composition 1 composed of the compound H1, a compound DF3 and the compound F1.
[Fig. 3] This is a schematic view showing a laminate structure of an organic electroluminescent device.
[Fig. 4] This shows emission spectra of an EL device 2 using the composition 1 as a light emitting layer, an EL device 1 in which the concentration of the compound F1 was changed to 0.5% by weight, an EL device 3 in which the concentration of the compound F1 was changed to 2.0% by weight, and a comparative EL device 1 not containing the compound F1 in a light emitting layer.

Description of Embodiments

The invention will be described in detail below. The constitutional elements may be described below with reference to representative embodiments and specific examples of the invention, but the invention is not limited to the embodiments and the examples. In the present specification, a numerical range expressed as "to" means a range that includes the numerical values described before and after "to" as the lower limit and the upper limit. The isotope species of the hydrogen atom existing in the molecule of the compound used in the present invention is not specifically limited, and for example, all hydrogen atoms in the molecule can be $^1$H, or a part or all can be $^2$H (deuterium D).
The "excitation light" in the present specification is a light that excites a targeted object to cause light emission, and a light having a wavelength that accords with the absorption wavelength of the targeted object can be used as the excitation light.
The "host material" in the present specification is a material contained in a mixed film of organic compounds, and is an organic compound whose lowest excited singlet energy is the highest among the organic compounds constituting the mixed film.

<Composition>

The composition of the present invention contains a first organic compound, a second organic compound of a delayed fluorescent material and a third organic compound of a fluorescent material, satisfying the following requirements (a) to (d).

$$\text{Requirement (a)} \qquad E_{S1}(1) > E_{S1}(2) > E_{S1}(3)$$

$$\text{Requirement (b)} \qquad \lambda^{E}_{EM}(2) < \lambda^{P}_{AB}(3) - 10\ \text{nm}$$

$$\text{Requirement (c)} \qquad \lambda^{P}_{EM}(3) < \lambda^{P}_{EM}(2)$$

$$\text{Requirement (d)} \qquad \lambda^P{}_{EM}(3) < 480 \text{ nm}$$

In these formulae, $E_{S1}(1)$ represents the lowest excited singlet energy of the first organic compound, $E_{S1}(2)$ represents the lowest excited singlet energy of the second organic compound, $E_{S1}(3)$ represents the lowest excited singlet energy of the third organic compound, $\lambda^E{}_{EM}(2)$ represents the emission wavelength (unit nm) on the short wavelength side of the second organic compound, $\lambda^P{}_{AB}(3)$ represents the wavelength (unit nm) of the peak top on the longest wavelength side of the absorption spectrum of the third organic compound, $\lambda^P{}_{EM}(2)$ represents the wavelength of the peak top of the emission spectrum of the second organic compound, $\lambda^P{}_{EM}(3)$ represents the wavelength of the peak top of the emission spectrum of the third organic compound.

The "delayed fluorescent material" in the present invention is a material that undergoes reverse intersystem crossing from the excited triplet state to the excited singlet state, and is preferably a thermal activation-type delayed fluorescent material that undergoes reverse intersystem crossing caused by thermal energy absorption. The delayed fluorescent material is identified as follows. When an emission transient decay curve of a thin film (single film) of the delayed fluorescent material or that of a mixed film composed of the delayed fluorescent material and a host material are observed at 20°C, both fluorescence having a short emission lifetime and fluorescence having a long emission lifetime (delayed fluorescence) are observed.

The "fluorescent material" in the present invention is a light emitting material as follows. When emission from a thin film (single film) of the fluorescent material or emission from a mixed film composed of the fluorescent material and a host material are observed at 20°C, the emission intensity of fluorescence is higher than the emission intensity of phosphorescence. Ordinary fluorescence (not delayed fluorescence) has an ns-order emission lifetime, while ordinary phosphorescence has an ms-order emission lifetime, and therefore fluorescence and phosphorescence can be differentiated by the emission lifetime thereof. The "fluorescent material" in the present invention can be a fluorescent material that does not emit delayed fluorescence, or can be a fluorescent material that emits delayed fluorescence (delayed fluorescent material). Here, the "fluorescent material that does not emit delayed fluorescence" is a fluorescent material from which fluorescence having a short emission lifetime at 20°C alone can be observed.

The measurement temperature for the "absorption spectrum" for $\lambda^P{}_{AB}(3)$ as defined in the present invention and for the "emission spectrum" for $\lambda^E{}_{EM}(2)$, $\lambda^P{}_{EM}(2)$ and $\lambda^P{}_{EM}(3)$ is 20°C. Regarding the specific description of the "absorption spectrum" and the "emission spectrum", reference can be made to the description of the definition of the physical data mentioned below.

In the present invention, the "lowest excited singlet energy of the first organic compound" ($E_{S1}(1)$), the "lowest excited singlet energy of the second organic compound" ($E_{S1}(2)$), and the "lowest excited singlet energy of the third organic compound" ($E_{S1}(3)$) are the values measured as follows. Thin films of the first organic compound, the second organic compound and the third organic compound (single films of each organic compound) are prepared as measurement samples, then the fluorescent spectra thereof are measured, and the wavelength $\lambda^E{}_{EM}$ at the spectrum end on the short wavelength side is converted into an energy value. Here, the fluorescent spectrum is a graph drawn by plotting the emission intensity detected by irradiation of the measurement sample with an excitation light at 20°C on the vertical axis, and the emission wavelength on the horizontal axis. A tangent line is drawn to the rising of the fluorescent spectrum on the short wavelength side, and the wavelength ($\lambda^E{}_{EM}$) [nm] at the intersection (the fluorescent spectrum end on the short wavelength side) between the tangent line and the horizontal axis is read. The wavelength value is converted into an energy value $E_{S1}$ according to the following conversion expression to be $E_{S1}(1)$, $E_{S1}(2)$ or $E_{S1}(3)$.

$$\text{Conversion Expression: } E_{S1}\ [\text{eV}] = 1239.85/\lambda^E{}_{EM}$$

In the present invention, the "emission wavelength (unit nm) on the short wavelength side of the second organic compound" ($\lambda^E{}_{EM}(2)$) is a wavelength at the spectrum end on the short wavelength side of the emission spectrum measured for a thin film of the second organic compound (single film of the second organic compound) as a measurement sample. The emission spectrum is a graph drawn by continuously varying the wavelength within a range of 900 to 190 nm, in which the emission intensity detected by photoirradiation of the measurement sample is on the vertical axis, and the wavelength is on the horizontal axis. A tangent line is drawn to the rising of the fluorescent spectrum on the short wavelength side, and the wavelength at the intersection (the fluorescent spectrum end on the short wavelength side) between the tangent line and the horizontal axis is read to be a wavelength $\lambda^E{}_{EM}(2)$ [nm].

In the present invention, the "wavelength (unit nm) of the peak top on the longest wavelength side of the absorption spectrum of the third organic compound" ($\lambda^P{}_{AB}(3)$) is an absorption maximum wavelength of the absorption peak positioned on the longest wavelength side in the absorption spectrum measured for a $10^{-5}$ M toluene solution of the third organic compound as a measurement sample. For example, in the case where the absorption spectrum has plural absorption peaks, the absorption maximum wavelength of the absorption peak positioned on the longest wavelength

side among them is referred to as the wavelength $\lambda^P_{AB}(3)$.

In the present invention, the "wavelength of the peak top of the emission spectrum of the second organic compound" ($\lambda^P_{EM}(2)$) is an emission maximum wavelength of the emission peak of the emission spectrum measured for a mixed film of the second organic compound and a host material as a measurement sample. Here, the "host material" is an organic compound whose lowest excited singlet energy is higher than the lowest excited single energy of the second organic compound $E_{S1}(2)$, and the concentration of the second organic compound in the mixed film is 30% by weight. In the case where the emission spectrum has plural emission peaks, the emission maximum wavelength of the emission peak having a highest intensity is $\lambda^P_{EM}(2)$.

In the present invention, the "wavelength of the peak top of the emission spectrum of the third organic compound" ($\lambda^P_{EM}(3)$) is an emission maximum wavelength of the emission peak of the emission spectrum measured for a mixed film of the third organic compound and a host material as a measurement sample. Here, the "host material" is an organic compound whose lowest excited singlet energy is higher than the lowest excited single energy of the third organic compound $E_{S1}(3)$, and the concentration of the third organic compound in the mixed film is 1% by weight. In the case where the emission spectrum has plural emission peaks, the emission maximum wavelength of the emission peak having a highest intensity is $\lambda^P_{EM}(3)$. The lower limit of $\lambda^P_{EM}(3)$ is not specifically limited, but is preferably 430 nm or more.

The composition of the present invention satisfies the requirements (a) to (d), and therefore exhibits light emission with an extremely high efficiency and a high color purity owing to the action of the TAF (TADF-assisted fluorescent) mechanism, therefore providing high color purity especially within a wavelength range of less than 480 nm. The mechanism is described here with reference to a case where the composition is made to emit light by current excitation. Here, the "TAF (TADF-assisted fluorescent) mechanism" in the present specification means that, owing to occurrence of reverse intersystem crossing in a delayed fluorescent material, the excited triplet energy is converted into an excited singlet energy, and the resultant excited single energy is moved to a fluorescent material by Foerster transfer and is thus utilized for fluorescence emission.

First, an electron and a hole are injected into the composition of the present invention, the electron and the hole are recombined to generate an excited singlet state and an excited triplet state at a generation probability of 25/75 in each organic compound. Here, when the requirement (a) is satisfied, the excited single energy generated in the first organic compound moves to the second organic compound and the third organic compound by Foerster transfer, and the excited singlet energy generated in the second organic compound and also the excited singlet energy that the second organic compound has received from the first organic compound move to the third organic compound by Foerster transfer. With that, the third organic compound thus having received the excited singlet energy emits fluorescence through radiative deactivation from the excited singlet state. Since the second organic compound is a delayed fluorescent material, the excited triplet state generated in the second organic compound changes to an excited singlet state through reverse intersystem crossing, and the excited singlet energy also moves to the third organic compound by Foerster transfer. Namely, here, the second organic compound functions as an assist dopant that converts the excited triplet energy to the excited singlet energy to be given to the third organic compound. Consequently, in the composition of the present invention, not only the excited singlet state energy generated by direct excitation but also the excited triplet energy generated by direct excitation can be utilized for fluorescence emission from the third organic compound, and for these reasons, the composition of the present invention can provide a high emission efficiency as compared with a fluorescent composition not using a delayed fluorescent material.

Here, in the composition of the present invention, the third organic compound satisfies the requirement (d) and the second organic compound and the third organic compound satisfy the requirements (a) and (c), and accordingly, the peak of the fluorescence emitted by the third organic compound has a peak top within a wavelength range of less than 480 nm, and has a narrower peak width than that of the emission peak in the case where the second organic compound emits light. In addition, since the requirement (b) is satisfied, the emission band of the second organic compound can overlap with the absorption peak on the longest wavelength side of the third organic compound. Consequently, energy transfer competition such that the excited singlet energy to move to the third organic compound through Foerster transfer moves to the second organic compound through Foerster transfer to cause radiative deactivation can be evaded, and the emission spectral shape of the composition can be suppressed from being broadened owing to the influence of light from the second organic compound.

From the above, the composition of the present invention satisfies the requirements (a) to (d), and therefore exhibits light emission with an extremely high efficiency and a high color purity, and can provide a high color purity especially within a wavelength range of less than 480 nm.

The requirements (a) to (d) are objective indices expressed by the magnitude correlation of numerical values, and therefore can clearly discriminate as to whether or not the composition can satisfy the requirements. Consequently, based on the requirements (a) to (d) as indices, the first organic compound, the second organic compound and the third organic compound are selected, and the composition that exhibits the above-mentioned characteristics can be surely realized.

Regarding the requirement (b), the second organic compound and the third organic compound preferably further

satisfy the following requirement (b1), more preferably the following requirements (b2) to (b4).

Requirement (b1) $\lambda^{E}_{EM}(2) < \lambda^{P}_{AB}(3)$ - 12 nm

Requirement (b2) $\lambda^{E}_{EM}(2) < \lambda^{P}_{AB}(3)$ - 15 nm

Requirement (b3) $\lambda^{E}_{EM}(2) < \lambda^{P}_{AB}(3)$ - 18 nm

Requirement (b4) $\lambda^{E}_{EM}(2) < \lambda^{P}_{AB}(3)$ - 20 nm

Further, the composition preferably satisfies the following requirement (e), more preferably the following requirement (e1). The composition satisfying the following requirements has a narrow skirt width of the emission peak and therefore exhibits light emission having a high color purity.

Requirement (e) $FW_{0.3M} < 40$ nm

Requirement (e1) $FW_{0.3M} < 32$ nm

In these formulae, $FW_{0.3M}$ represents the spectral width in which the relative intensity to the emission peak of the emission spectrum of the composition is 30%.

Further, the second organic compound and the third organic compound preferably satisfy the following requirements (f) and (g). With that, electrons and holes can be more readily injected into the second organic compound than the third organic compound, and the second organic compound can more effectively exhibit the assist dopant function thereof.

Requirement (f) LUMO(2) ≤ LUMO(3)

Requirement (g) HOMO(2) ≤ HOMO(3)

In the above formulae, LUMO(2) represents the LUMO (lowest unoccupied molecular orbital) energy of the second organic compound, LUMO(3) represents the LUMO energy of the third organic compound, HOMO(2) represents the HOMO (highest occupied molecular orbital) energy of the second organic compound, HOMO(3) represents the HOMO energy of the third organic compound.

Here, the LUMO energy is a value calculated by subtracting the band gap from the ionization potential measured for a thin film of the compound targeted for measurement (a single film of the compound targeted for measurement) followed by giving a sign "-" (minus sign) thereto, and the HOMO energy is a value of the ionization potential given a sign "-" (minus sign). The band gap is estimated from the wavelength at the absorption spectrum end on the long wavelength side. The ionization potential is measured in photoelectron spectroscopy, for which, for example, a photoelectron spectroscopic apparatus (AC-3 by Riken Keiki Co., Ltd.) can be used.

Also preferably, the second organic compound and the third organic compound satisfy the following requirement (h), also preferably satisfy the following requirement (i), also preferably satisfy the following requirement (j), more preferably satisfy at least two of the following requirements (h), (i) and (j), even more preferably satisfy all the following requirements (h), (i) and (j). With that, Foerster transfer of the excited singlet energy from the second organic compound to the third organic compound can occur more readily so that the emission efficiency and the color purity in light emission can be enhance more.

Requirement (h) $R_0(2\text{-}3) > 6.5$ nm

In the formula, $R_0(2\text{-}3)$ represents the Foerster radius between the second organic compound and the third

organic compound.

Requirement (i) $r(2\text{-}3) < 3.91$ nm

In the formula, r(2-3) represents the intermolecular distance between the second organic compound and the third organic compound.

Requirement (j) $k_{FRET}(2\text{-}3) > 1.5\times10^{9}\ s^{-1}$

In the formula, $k_{FRET}$(2-3) represents the Foerster energy transfer speed constant between the second organic compound and the third organic compound.

Further more preferably, the second organic compound and the third organic compound satisfy all the following requirements (h1), (i1) and (j 1).

Requirement (h1) $R_0(2\text{-}3) \geq 7.3$ nm

Requirement (i1) $r(2\text{-}3) \leq 3.71$ nm

Requirement (j1) $k_{FRET}(2\text{-}3) \geq 6.1\times10^{9}\ s^{-1}$

Regarding the definition of $R_0$(2-3), r(2-3) and $k_{FRET}$(2-3) in the above formulae, reference can be made to the corresponding definition in the requirements (h), (i) and (j).

Here, the "Foerster radius between the second organic compound and the third organic compound" ($R_0$(2-3)) is a value to be calculated according to the following numerical expression.

$$R_0^6 = \frac{9000 \cdot c^4 \cdot \ln(10) \cdot \Phi_{PL}}{128 \cdot \pi^5 \cdot n^4 \cdot N_A} \int f_{TADF}(v)\, \varepsilon_{Flu}(v) \frac{dv}{v^4}$$

wherein c represents the speed of light, $\varphi_{PL}$ represents the emission efficiency of the second organic compound, n represents the refractive index of the first organic compound, $N_A$ represents the Avogadro constant, $f_{TADF}$(v) represents the emission spectrum of the second organic compound, $\varepsilon_{Flu}$(v) represents the absorption spectrum of the third organic compound, and v represents the wavenumber.

The "intermolecular distance between the second organic compound and the third organic compound" (r(2-3)) is determined from the coordinates of the first organic compound, the second organic compound and the third organic compound according to a classic molecular dynamics method (MD). For the MD calculation method, a LAMMPS program is used, in which, for the initial structure of the molecular structure of each material, the most stable structure derived from the first-principle calculation is used. For the first-principle calculation, a quantum chemical calculation program Gaussian 09 is used, and the most stable structure is calculated by density functional theory (DFT). The distance at which the coordination number is 1 by the MD calculation is the value r(2-3).

The "Foerster energy transfer speed constant $k_{FRET}$(2-3)" is a value to be calculated according to the following numerical expression.

$$k_{FRET} = k_{prompt} \left( \frac{R^0}{r} \right)^6$$

$$R^0 \propto J^{1/6}$$

In the formulae, r represents the distance between the chromophores of the second organic compound and the third organic compound, *J* represents the spectral overlap density integral, and is a value calculated according to the following numerical expression.

$$\int f_{TADF}(v)\, \varepsilon_{Flu}(v) \frac{dv}{v^4}$$

The light emission from the composition of the present invention contains the fluorescence from the third organic compound. The light emission from the composition of the present invention can contain only the fluorescence component from the third organic compound or can partly contain the light emission component from the first organic compound and the second organic compound, but preferably the maximum component of light emission from the composition is the fluorescence from the third organic compound. Here, the maximum component of light emission from the composition is the fluorescence from the third organic compound, which can be confirmed by the fact that, in the emission spectrum of the composition, the area of the emission peak derived from the third organic compound is more than 50% of the area of the total emission peak. The proportion of the fluorescence component derived from the third organic compound in the light emission from the composition is more preferably more than 60%, even more preferably more than 70%, further more preferably more than 80%, and especially more preferably more than 90%.

In the following, compounds usable as the second organic compound, the third organic compound and the first organic compounds are described specifically.

[Second Organic Compound]

Examples of compounds usable as the second organic compound include the compounds represented by the following general formula (1).

General Formula (1)

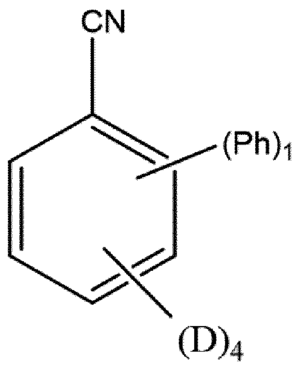

In the general formula (1), D represents a substituted or unsubstituted carbazol-9-yl group. D can be an unsubstituted carbazol-9-yl group, or can also be a carbazol-9-yl group in which at least one hydrogen atom is substituted with a substituent (substituted carbazol-9-yl group). All four D's have the same chemical structure. The number of the substituents of the substituted carbazol-9-yl group is not specifically limited, and can be 1 to 8. Also the position of the substituent is not specifically limited, but preferably at least one of the 3-position and the 6-position is a substituent. When the substituted carbazol-9-yl group has two or more substituents, the plural substituents can be the same as or different from each other. Examples of the substituent in the substituted carbazol-9-yl group include an alkyl group, an aryl group, and a heteroaryl group, and these substituents can further be substituted with an alkyl group, an aryl group and a heteroaryl group. In the carbazol-9-yl group, the adjacent substituents can bond to each other to form a cyclic structure. Examples of the cyclic structure formed by the substituents bonding to each other include a benzofuran ring, a benzothiophene ring, and an indole ring, and these cyclic structures can be substituted with an alkyl group and an aryl group.

The alkyl group as the substituent of the carbazol-9-yl group can be any of linear, branched or cyclic ones. The carbon number is preferably 1 to 20, more preferably 1 to 10, even more preferably 1 to 6. Examples of the alkyl group include a methyl group, an ethyl group, an n-propyl group and an isopropyl group.

The aromatic ring that constitutes the aryl group can be a single ring, or can be a condensed ring formed by condensation of two or more aromatic rings, or can be a linked ring formed by link of two or more aromatic rings. In the case where two or more aromatic rings link, they may link linearly, or may link in a branched manner. The carbon number of the aromatic ring that constitutes the arly group is preferably 6 to 40, more preferably 6 to 22, even more preferably 6 to 18, further more preferably 6 to 14, and especially more preferably 6 to 10. Specific examples of the aryl group include a phenyl group, a naphthalenyl group, and a biphenyl group.

The hetero ring that constitutes the heteroaryl group can be a single ring, or can be a condensed ring formed by condensation of one or more hetero rings and one or more aromatic rings or hetero rings. The carbon number of the hetero ring to constitute the heteroaryl group is preferably 3 to 40, more preferably 5 to 22, even more preferably 5 to 18, further more preferably 5 to 14, and especially more preferably 5 to 12. The hetero atom that constitutes the hetero ring is preferably at least one of a nitrogen atom, an oxygen atom and a sulfur atom. Specific examples of the heteroaryl group include a carbazol-9-yl group, a 10H-phenoxazin-10-yl group, a 10H-phenothiazin-10-yl group, and a 9,10-dihydroacridin-10-yl group.

The substituted carbazol-9-yl group of D preferably has a structure represented by any of the following D1 to D37. In the following D1 to D37, the wiggly line indicates a substitution position in the benzene ring.

D1
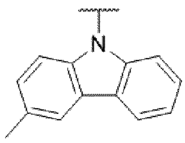
D2
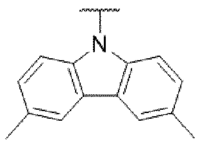
D3
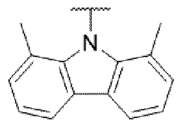
D4
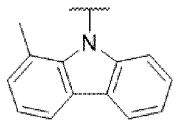

D5
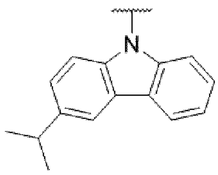
D6
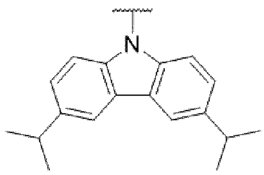
D7
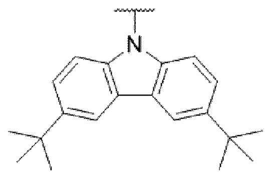
D8
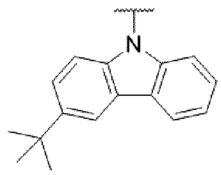

D9
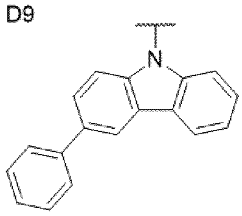
D10
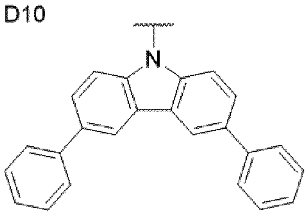
D11
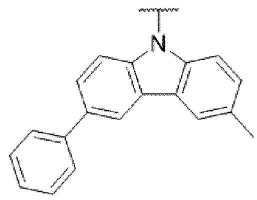
D12
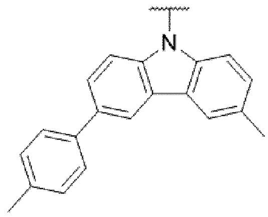

D13
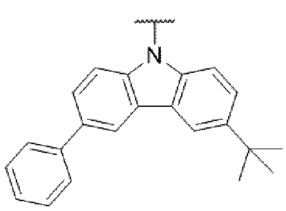
D14
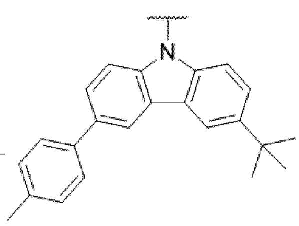
D15
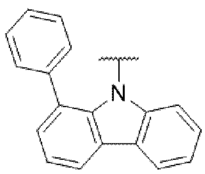
D16
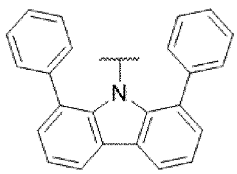

D17

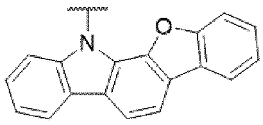

D18

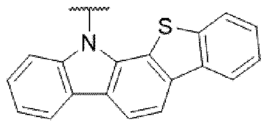

D19

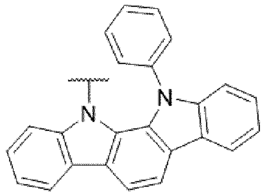

D20

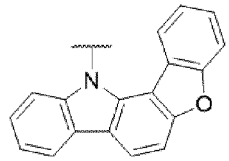

D21

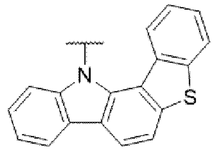

D22

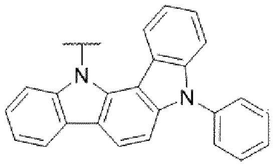

D23

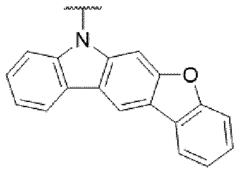

D24

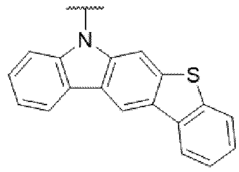

D25

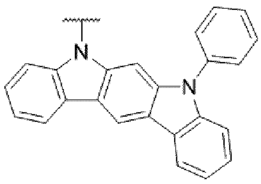

D26

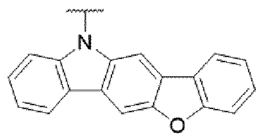

D27

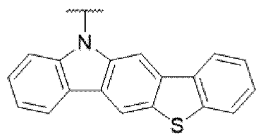

D28

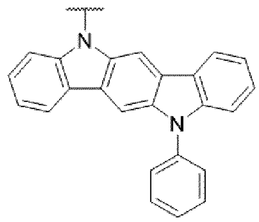

D29

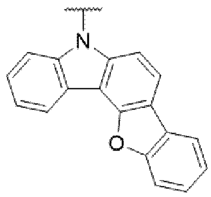

D30

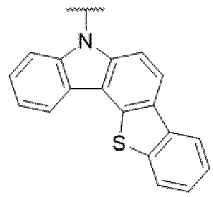

D31

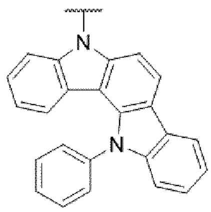

D32

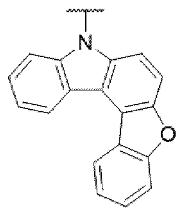

D33

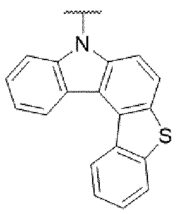

D34

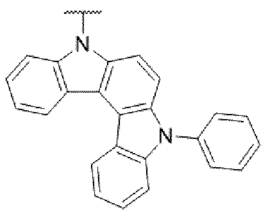

D35

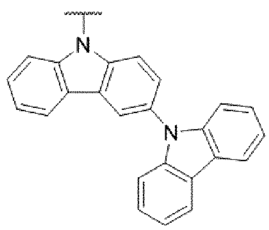

D36

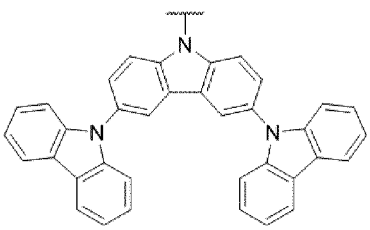

D37

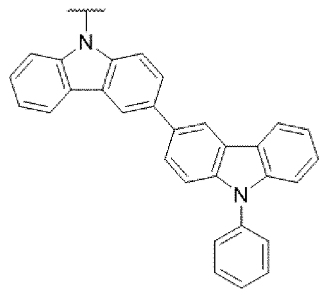

In the general formula (1), Ph represents a phenyl group optionally substituted with at least one group selected from the group consisting of an alkyl group, an aryl group and a group of these groups linking together. In the following description, "at least one group selected from the group consisting of an alkyl group, an aryl group and a group of these groups linking together" can be referred to as "Substituent A". The phenyl group of Ph can be an unsubstituted, or can be a phenyl group in which at least one hydrogen atom is substituted with Substituent A (substituted phenyl group). When the phenyl group is substituted with Substituent A, the number of Substituent A is not specifically limited, and can be any of 1 to 5. Also the position of the Substituent A is not specifically limited, and may be any of 2- to 6-positions. When the phenyl group has two or more Substituents A's, the plural Substituents A's can be the same as or different from each other.

Regarding the description and the preferred range and specific examples of the alkyl group and the aryl group, reference can be made to the description and the preferred range and specific examples of the alkyl group and the aryl group exemplified as the substituents for the carbazol-9-yl group mentioned hereinabove.

The group of an alkyl group and an aryl group linking together can be an arylalkyl group or an alkylaryl group. The number of the aryl groups with which the alkyl group is substituted, and the number of the alkyl groups with which the aryl group is substituted can be one, or can be two or more. When the alkyl group is substituted with two or more aryl groups, the plural aryl groups can be the same as or different from each other. When the aryl group is substituted with two or more alkyl groups, the plural alkyl groups can be the same as or different from each other. The aryl group as a substituent for the alkyl group, and the alkyl group as a substituent for an aryl group can be further substituted with one or more alkyl groups and one or more aryl groups. Regarding the description and the preferred range and specific examples of the alkyl group and the aryl group, reference can be made to the description and the preferred range and specific examples of the alkyl group and the aryl group exemplified as the substituents for the carbazol-9-yl group.

In the general formula (1), the substitution position of the four D's and Ph in the benzene ring is not specifically limited. For example, the substitution position of Ph can be any of the ortho-position, the meta-position or the para-position relative to the group CN, but is preferably the para-position. In the case where the substitution position of Ph is any position, the remaining substitutable positions of the benzene ring are the substitution positions of four D's.

The compound to be used as the second organic compound is preferably a compound represented by the following general formula (1a).

General Formula (1a)

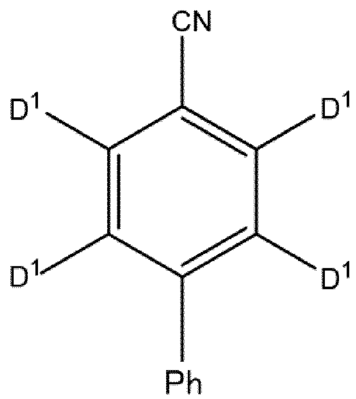

In the general formula (1a), $D^1$ represents a substituted or unsubstituted carbazol-9-yl group. All four $D^1$'s have the same chemical structure. Ph represents a phenyl group optionally substituted with at least one group selected from

the group consisting of an alkyl group, an aryl group and a group of these groups linking together.

Regarding the description and the preferred range and specific examples of $D^1$, reference can be made to the description and the preferred range and specific examples of D in the above general formula (1) except for the description of the substitution position thereof, and regarding the description and the preferred range and specific examples of Ph, reference can be made to the description and the preferred range and specific examples of Ph in the above general formula (1) except for the description of the substitution position thereof.

Examples of the compound usable as the second organic compound include compounds represented by the following general formula (2).

General Formula (2)

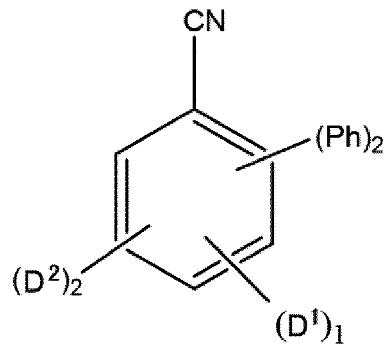

In the general formula (2), $D^1$ represents a substituted or unsubstituted carbazol-9-yl group, $D^2$ represents a substituted or unsubstituted carbazol-9-yl group that differs from $D^1$. The two $D^2$'s have the same chemical structure.

$D^1$ and $D^2$ each can be an unsubstituted carbazol-9-yl group, or can also be a carbazol-9-yl group in which at least one hydrogen atom is substituted with a substituent (substituted carbazol-9-yl group). Regarding the description and the preferred range and specific examples of the substituted carbazol-9-yl group, reference can be made to the description and the preferred range and specific examples of the substituted carbazol-9-yl group of D mentioned hereinabove. However, in the general formula (2), $D^2$ represents a substituted or unsubstituted carbazol-9-yl group that differs from $D^1$. The substituted or unsubstituted carbazol-9-yl group that $D^1$ represents, and the substituted or unsubstituted carbazol-9-yl group that $D^2$ represents can differ from each other in any of the presence or absence of the substituent, the number of the substituents, and the structure and the substitution position of the substituent.

Two Ph's each independently represent a phenyl group optionally substituted with at least one group selected from the group consisting of an alkyl group, an aryl group and a group of these groups linking together. The two Ph's can be the same as or different from each other. Regarding the description and the preferred range and specific examples of the "phenyl group optionally substituted with at least one group selected from the group consisting of an alkyl group, an aryl group and a group of these groups linking together" that Ph represents, reference can be made to the description and the preferred range and specific examples of the "phenyl group optionally substituted with at least one group selected from the group consisting of an alkyl group, an aryl group and a group of these groups linking together" that Ph in the general formula (1) represents.

In the general formula (2), the substitution position of $D^1$, $D^2$ and Ph in the benzene ring is not specifically limited. For example, the substitution position of two Ph's can be any of the ortho-position, the meta-position or the para-position to the group CN, and in any case, the remaining substitutable positions are the substitution position of $D^1$, and two $D^2$'s. Preferred substitution positions for two Ph's are the ortho-position and the para-position to the group CN. A preferred substitution position for $D^2$ is the meta-position to the group CN.

The compound to be used as the second organic compound is also preferably a compound represented by the following general formula (2a).

General Formula (2a)

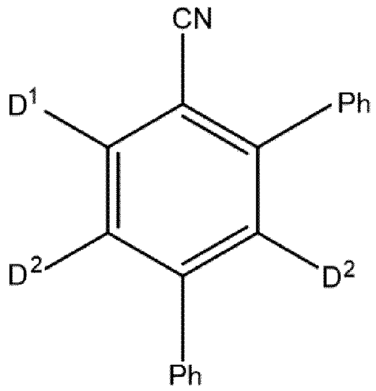

In the general formula (2a), $D^1$ represents a substituted or unsubstituted carbazol-9-yl group, $D^2$ represents a substituted or unsubstituted carbazol-9-yl group that differs from $D^1$. Two $D^2$'s have the same chemical structure. Two Ph's each independently represent a phenyl group optionally substituted with at least one group selected from the group consisting of an alkyl group, an aryl group and a group of these groups linking together. Two Ph's can be the same as or different from each other.

Regarding the description of $D^1$, $D^2$, and Ph, reference can be made to the description of $D^1$, $D^2$, and Ph in the above general formula (2) except for the description of the substitution position in the benzene ring.

Specific examples of compounds usable as the second organic compound are shown below. However, the second organic compound usable in the present invention should not be limitatively interpreted by these specific examples.

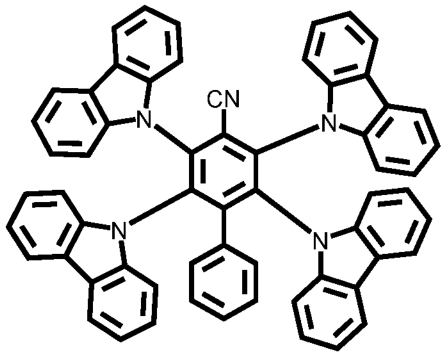

DF1

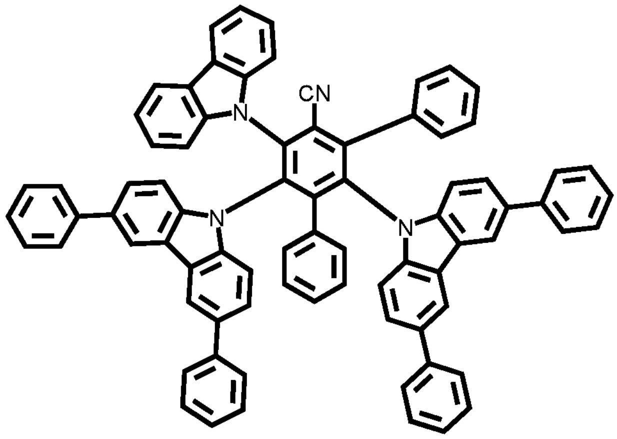

DF2

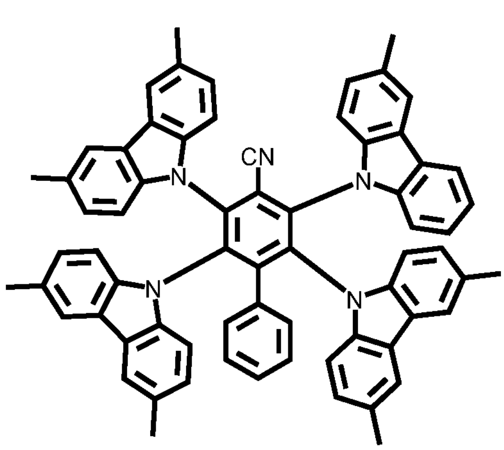

DF3

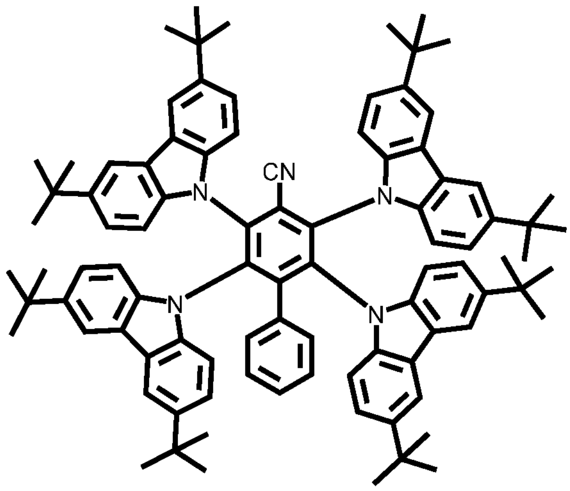

DF4

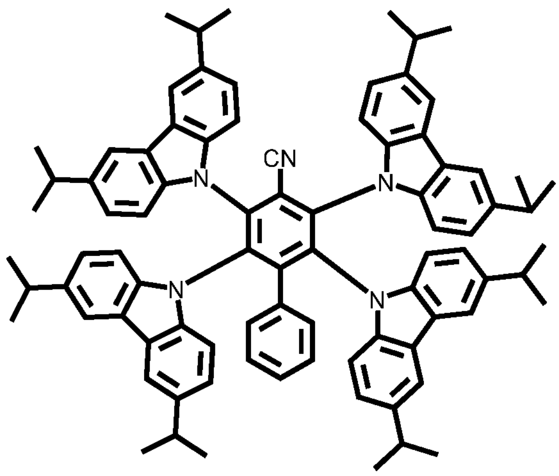

DF5

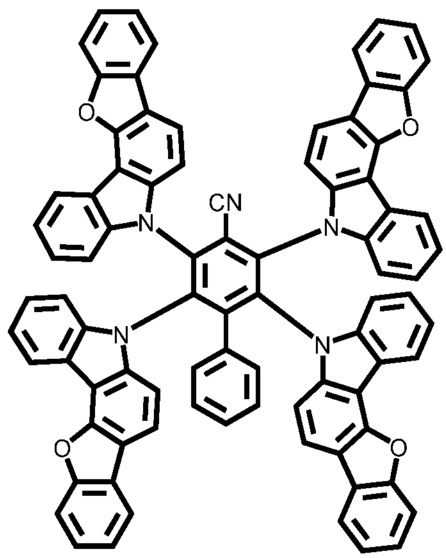

DF6

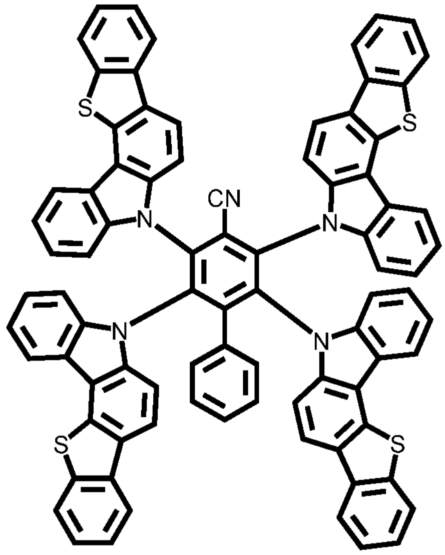

DF7

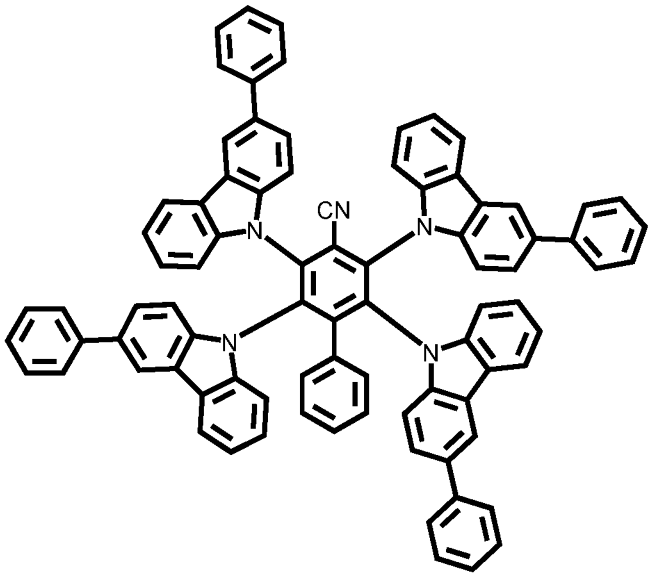

DF8

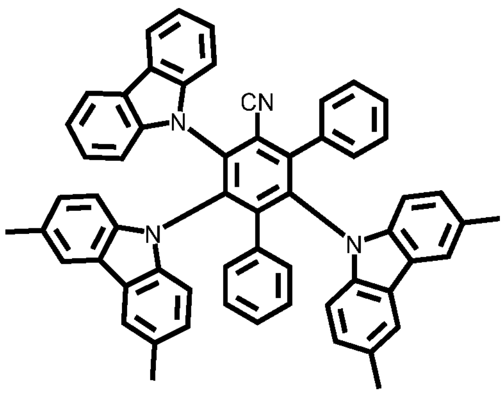

DF9

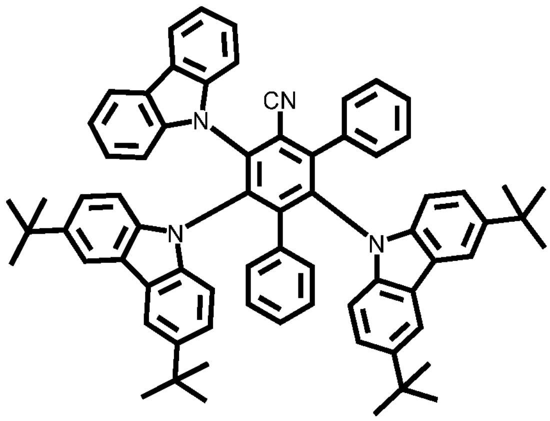

DF10

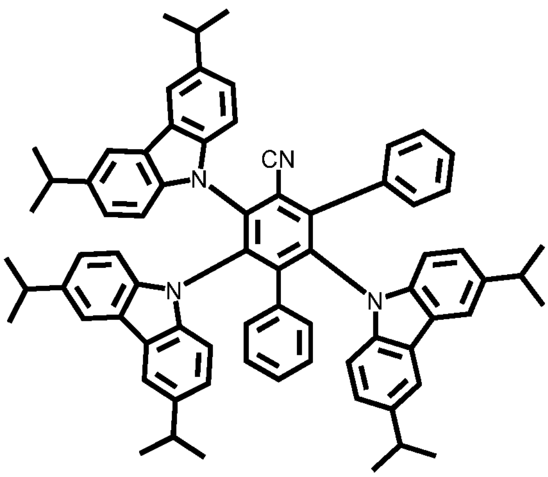

DF11

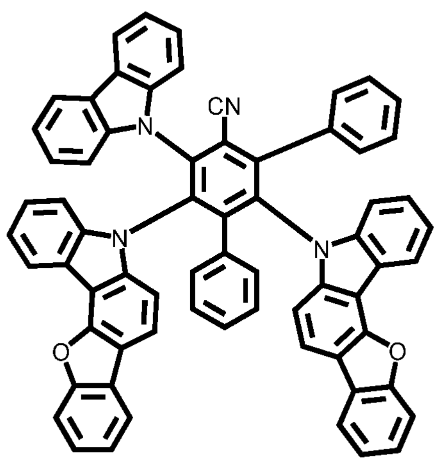

DF12

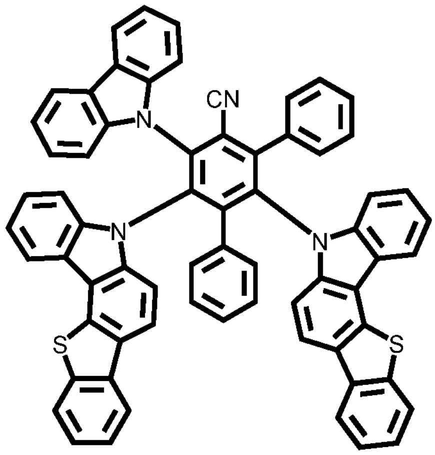

DF13

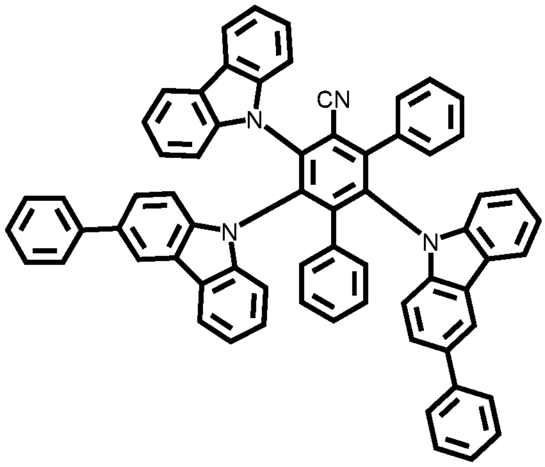

DF14

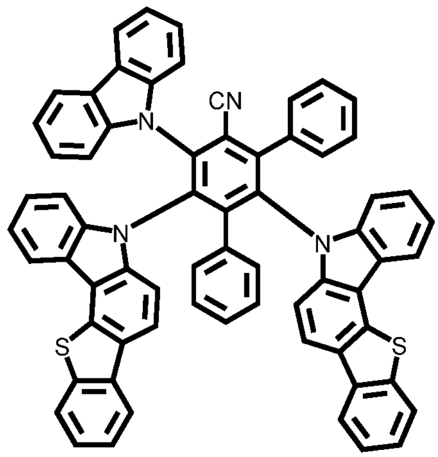

DF15

[Third Organic Compound]

The third organic compound is preferably a multiple resonance-type fluorescent material, more preferably a multiple resonance-type delayed fluorescent material.

The third organic compound is preferably a compound capable of multiple resonance between one or more atoms selected from the group consisting of a nitrogen atom, an oxygen atom and a sulfur atom, and a boron atom.

Compounds represented by the general formula and specific compounds described in the paragraphs [0011] to [0032] in WO2020/039930, which is hereby incorporated by reference as a part of the present specification, and a compound represented by the following formula are favorably used as the third organic compound.

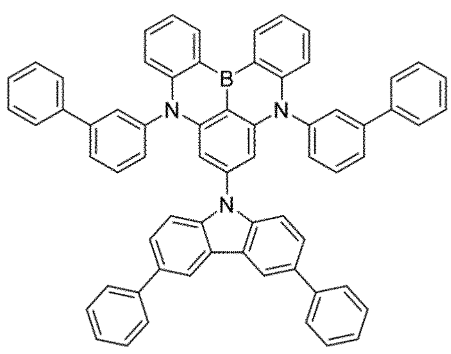

[First Organic Compound]

The first organic compound is an organic compound whose lowest excited singlet energy is higher than that of the second organic compound and the third organic compound, and can be selected and used, for example, from known host materials.

Specific examples of compounds usable as the third organic compound are shown below. However, the third organic compound for use in the present invention should not be limitatively interpreted by these specific examples.

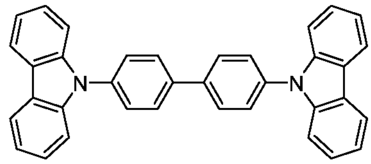
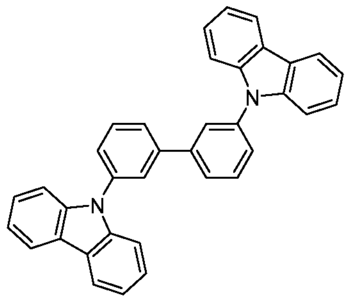
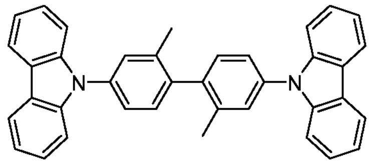
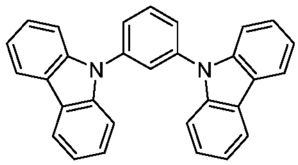
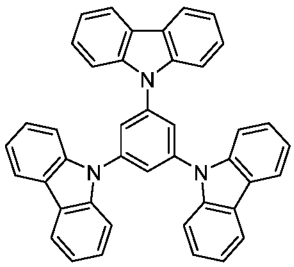
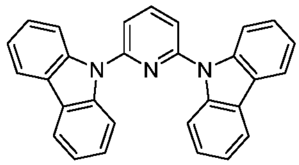
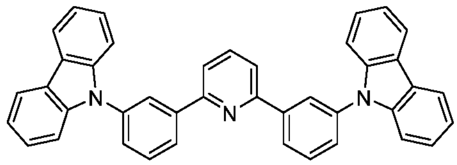
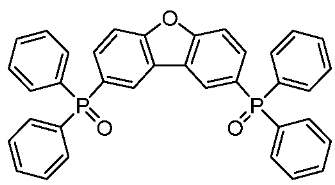
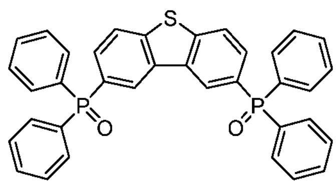
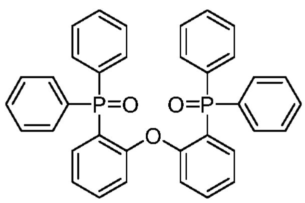
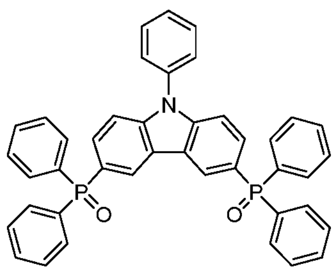
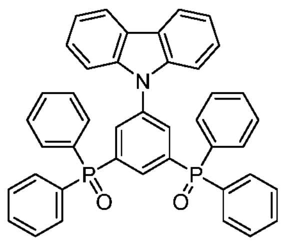
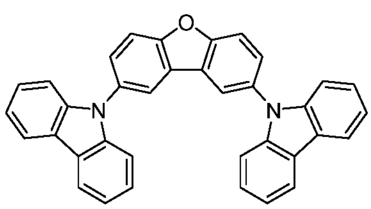
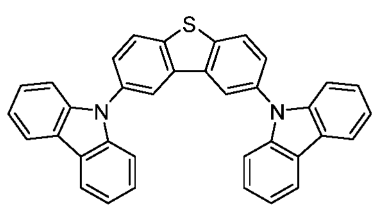
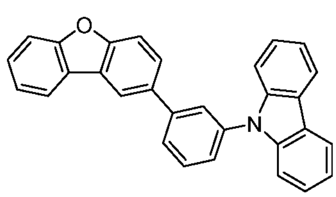

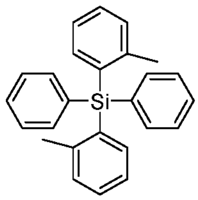
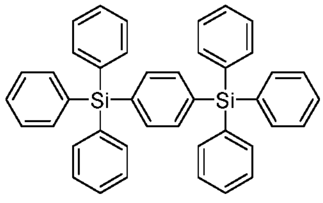
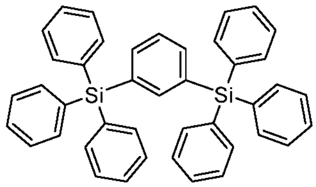
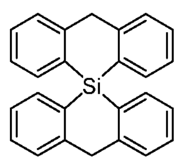

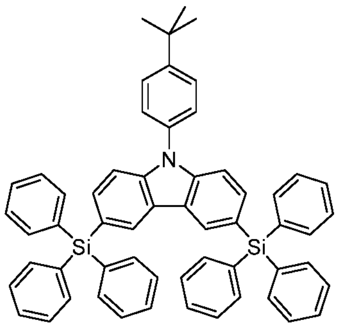
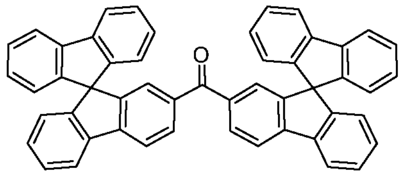
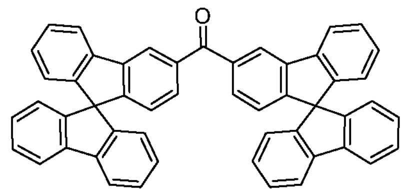

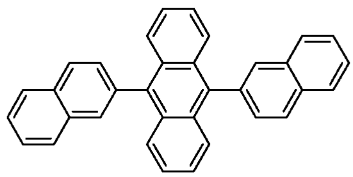
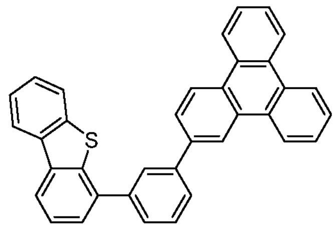
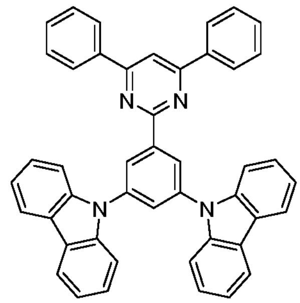

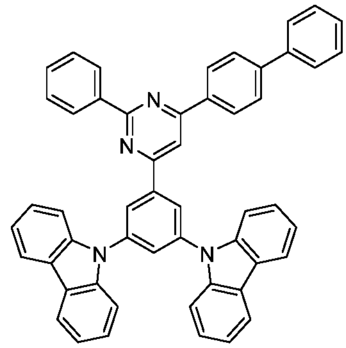
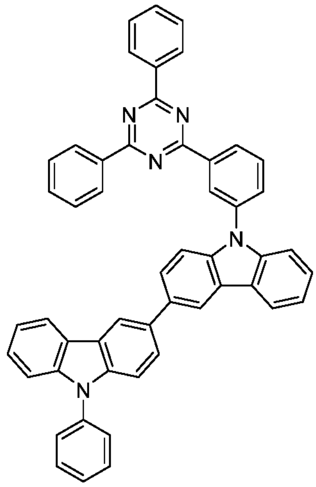
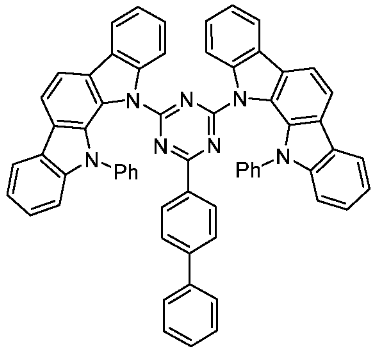

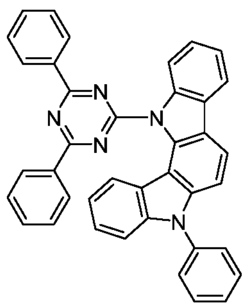

[Blending Ratio of First Organic Compound, Second Organic Compound and Third Organic Compound]

In the composition of the present invention, the blending ratio of the first organic compound, the second organic compound and the third organic compound is not specifically limited, but preferably, the content of the second organic compound is smaller than the content of the first organic compound and is larger than the content of the third organic compound, that is, the blending ratio preferably satisfies a relationship of "content of third organic compound < content of second organic compound < content of first organic compound".

Specifically, the content of the second organic compound in the composition is preferably less than 50% by weight relative to the total amount of the first organic compound and the second organic compound and the third organic compound. Further, the upper limit of the content of the second organic compound is preferably less than 40% by weight relative to the total amount of the first organic compound and the second organic compound and the third organic compound, and, for example, can be less than 30% by weight, less than 20% by weight, or less than 10% by weight. The lower limit is preferably 0.1% by weight or more, and can be, for example, more than 1% by weight, or more than 3% by weight.

The content of the third organic compound in the composition can be 0.1% by weight or more, or 1% by weight or more, relative to the total amount of the first organic compound and the second organic compound and the third organic compound. The content of the third organic compound in the composition can be 30% by weight or less, or 20% by weight or less, or 10% by weight or less.

[Other Components in Composition]

The composition of the present invention can be composed of only the first organic compound, the second organic compound and the third organic compound, or can contain any other component.

<Use as Light Emitting Composition>

As described above, the composition of the present invention exhibits light emission with an extremely high efficiency and a high color purity, and especially can provide a high color purity within a wavelength range of less than 480 nm. Consequently, the composition of the present invention can be effectively used as a light emitting composition. Embodiments of use of the composition of the present invention as a light emitting composition are not specifically limited, and examples thereof include an embodiment of forming the composition into a film and using it as a light emitting film; an embodiment of using the light emitting film as a light emitting layer in an organic light emitting device, and an embodiment of dissolving the composition in a solvent and using the resultant solution as a liquid-type light emitting material. Regarding the constitution of the light emitting film using the composition of the present invention, reference can be made to the description in the section of <Film> and <Light Emitting Film> given hereunder; and regarding the constitution of the organic light emitting device using the composition of the present invention as the light emitting layer, reference can be made to the description in the section of <Organic Light Emitting Device> given hereunder.

<Film>

Next, the film of the present invention is described.

The film of the present invention is characterized by containing the composition of the present invention.

Regarding the description of the composition of the present invention, reference can be made to the description in the section of <Composition> given hereinabove.

As described above, the composition of the present invention exhibits light emission with an extremely high efficiency and a high color purity, and provides a high color purity especially within a wavelength range of less than 480 nm. Consequently, the film containing the composition also exhibits excellent properties reflecting the properties of the composition.

The film of the present invention can be formed as follows.

In some embodiments, the film containing the composition of the present invention can be formed in a wet process. In the wet process, a solution of the composition of the present invention is applied to a substrate surface and then the solvent is removed to form a film. The wet process includes, though not limited thereto, a spin coating method, a slit coating method, an inkjet method (spray method), a gravure printing method, an offset printing method, and a flexographic printing method. In the wet process, a suitable organic solvent capable of dissolving the composition of the present invention is selected and used. In some embodiments, a substituent (for example, an alkyl group) capable of increasing the solubility in an organic solvent can be introduced into the organic compound contained in the composition.

In some embodiments, the film containing the composition of the present invention can be formed in dry process. In some embodiments, a vacuum evaporation method can be employed as the dry process, though not limited thereto.

In the case where a vacuum evaporation method is employed, the organic compounds constituting the composition can be co-evaporated from individual evaporation sources, or can be co-evaporated from a single evaporation source prepared by mixing all the organic compounds. In the case where a single evaporation source is used, a mixed powder prepared by mixing powders of all the organic compounds can be used, or a compressed-molded article prepared by compression-molding the mixed powder can be used, or a mixture prepared by heating, meting and mixing the organic compounds and then cooling the resultant mixture can be used. In some embodiments, plural organic compounds contained in a single evaporation source are co-evaporated under the condition that the evaporation speed (weight reducing speed) is the same or is nearly the same between the plural organic compounds to thereby form a film having a compositional ratio corresponding to the compositional ratio of the plural organic compounds contained in the evaporation source. When plural organic compounds are mixed to prepare an evaporation source in the same compositional ratio as the compositional ratio of the film to be formed, a film having a desired compositional ratio can be formed in a simple manner. In some embodiments, a temperature at which the organic compounds to be co-evaporated could have the same weight reduction rate is specifically defined, and the temperature can be employed as the temperature for co-evaporation.

The film of the present invention can have a single-layer configuration or a multilayer configuration. In the case where the film of the present invention has a multilayer configuration, the constituent layers can differ in at least one kind of the first organic compound, the second organic compound and the third organic compound, and can differ in the compositional ratio of the compounds, and can differ in the presence or absence of any other component therein.

The thickness of the film of the present invention is preferably 10 to 100 nm, more preferably 20 to 60 nm, even more preferably 30 to 50 nm. In the case where the film of the present invention has a multilayer configuration, the preferred range of the thickness of each film is to fall within the above-mentioned thickness range.

<Use as Light Emitting Film>

As described above, the film of the present invention exhibits light emission with an extremely high efficiency and a high color purity, and can provide a high color purity especially within a wavelength range of less than 480 nm. Consequently, the film of the present invention can be effectively used as a light emitting film.

Regarding the description of the film of the present invention, reference can be made to the description in the section of <Film> given hereinabove.

The light emitting film of the present invention can bae effectively used as the light emitting layer of an organic light emitting device. Regarding the configuration of the organic light emitting device using the light emitting film of the present invention as the light emitting layer therein, reference can be made to the description in the section of <Organic Light Emitting Device> given hereinunder.

<Organic Light Emitting Device>

The composition of the present invention contains the first organic compound, the second organic compound and the third organic compound satisfying predetermined requirements, and therefore owing to the TAF mechanism thereof, exhibits light emission with an extremely high efficiency and a high color purity, and can provide a high color purity especially within a wavelength range of less than 480 nm. Consequently, the composition of the present invention can be effectively used as a material for the light emitting layer of a TAF-type organic light emitting device, and is especially favorable as a material for the light emitting layer of an organic electroluminescent device.

Here, in the description of use examples, devices, displays and screens given in [0141] to [0169] and [0192] to [0242] in US2020/0168814A1, the material of "light emitting layer" is replaced with "the composition of the present invention", and the entirety thereof is hereby cited as a part of the present specification to be the description of the present invention.

A preferred embodiment of an organic electroluminescent device (the organic electroluminescent device of the present invention) is an organic electroluminescent device having an anode, a cathode, and at least one organic layer containing a light emitting layer between the anode and the cathode, wherein the light emitting layer contains the composition of the present invention, and the maximum component of light emission from the device is fluorescence from the third organic compound.

Regarding the description of the composition of the present invention, reference can be made to the description in the section of <Composition> given hereinabove.

The maximum component of light emission from the device is fluorescence from the third organic compound, which can be confirmed from the fact that, in the emission spectrum of the organic electroluminescent device, the area of the emission peak derived from the third organic compound is more than 50% of the total emission peak area. The proportion of the fluorescence component derived from the third organic compound in the light emission from the device is more preferably more than 60%, even more preferably more than 70%, further more preferably more than 80%, and

especially more preferably more than 90%. The wavelength of the emission peak derived from the third organic compound (wavelength of the emission peak from the organic electroluminescent device) is not limited, but in a preferred embodiment, the wavelength falls within a blue emission region (400 nm to 490 nm), in a more preferred embodiment, it is 420 nm to 480 nm.

In the organic electroluminescent device of the present invention, the organic layer contains at least a light emitting layer, and can be composed of a light emitting layer alone, or can contain any other one or more organic layers in addition to a light emitting layer. Such other organic layers include a hole transport layer, a hole injection layer, an electron blocking layer, a hole blocking layer, an electron injection layer, an electron transport layer, and an exciton blocking layer. The hole transport layer can be a hole inj ection-transport layer having a hole injection function, and the electron transport layer can be an electron injection-transport layer having an electron injection function.

The organic electroluminescent device of the present invention can be a bottom-emission type that emits light from the substrate side, or can be a top-emission type that emits light from the side opposite to the substrate, but is preferably a top-emission type. In the bottom-emission type organic electroluminescent device, the electrode on the substrate side (one electrode) of a pair of electrodes is formed of a transparent electrode, while in the top-emission type organic electroluminescent device, the electrode on the side opposite to the substrate (one electrode) of a pair of electrodes is formed of a transparent electrode. The other electrode can be any of a transparent electrode, a semi-transparent electrode or a reflecting electrode, but when it is a transparent electrode or a semi-transparent electrode, a reflecting layer formed of a metal simple substance or an alloy can be provided adjacent to the electrode.

Hereinunder preferred materials for use for the organic electroluminescent device are specifically exemplified. However, the materials usable in the present invention should not be limitatively interpreted by the following exemplary compounds. Even the compounds exemplified as materials having a specific function can be diverted to materials having some other function.

In some embodiments of the present invention, the following compounds can be favorably used as an electron blocking material.

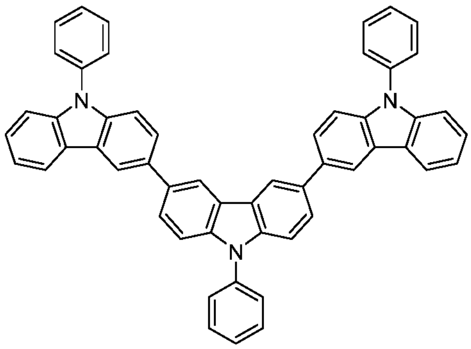
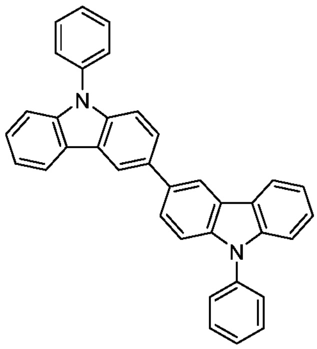
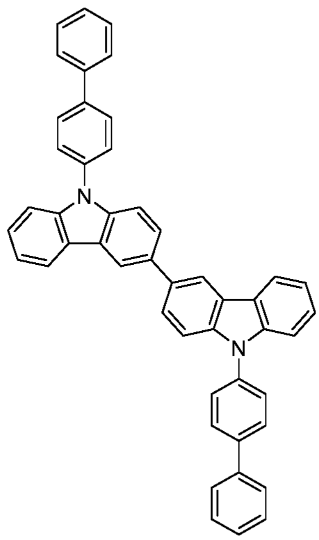
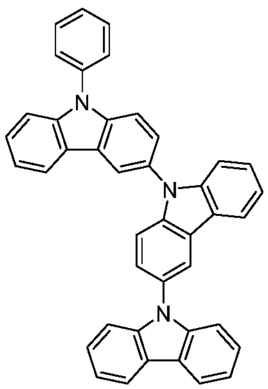
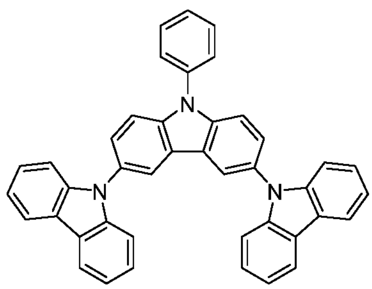
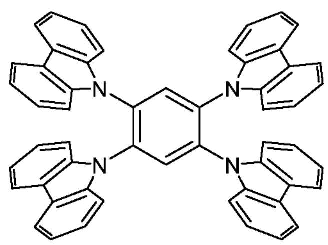

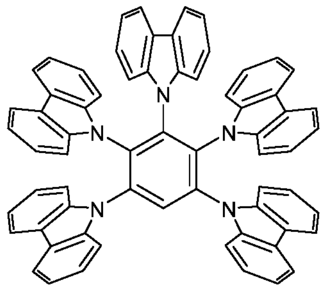

In some embodiments of the present invention, the following compounds can be favorably used as a hole blocking material.

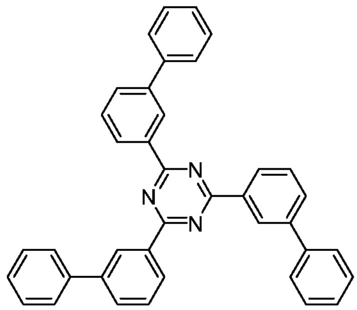

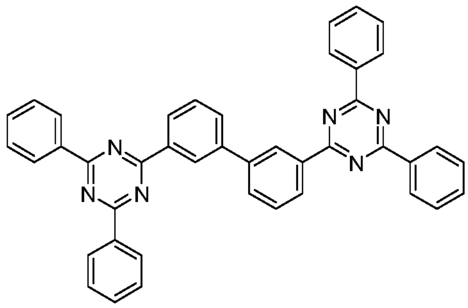

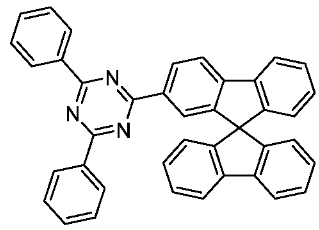

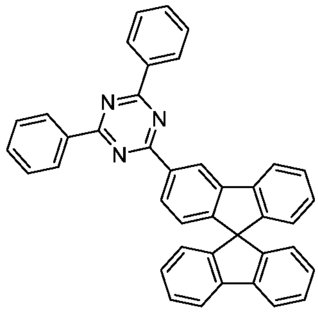

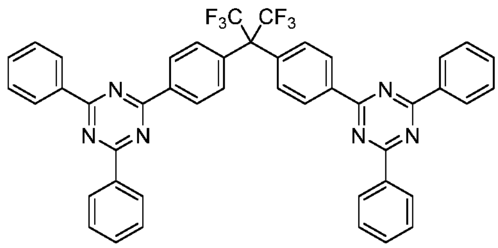

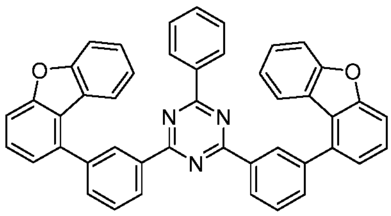

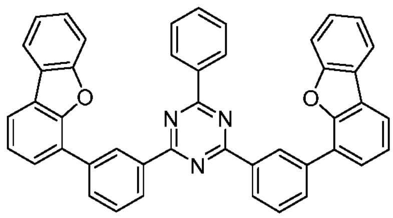

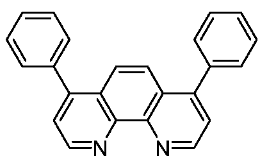

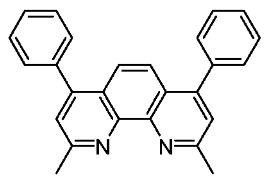

Preferred compound examples usable as a hole injection material in the organic electroluminescent device are shown below.

MoOs,

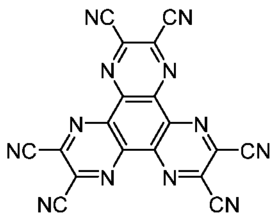
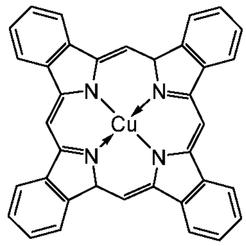
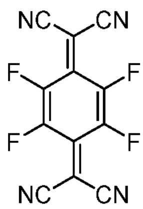
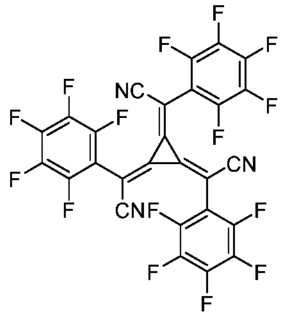

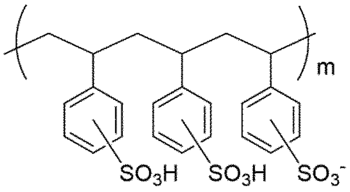
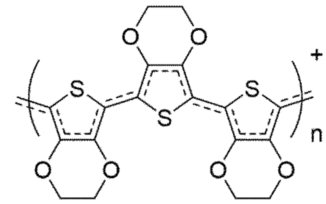

Preferred compound examples usable as an electron injection material in the organic electroluminescent device are shown below.
LiF, CsF,

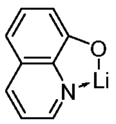

Further, compound examples preferred as a material that can be added to the organic layers of the organic electroluminescent device are shown below. For example, these can be added as a stabilizing material.

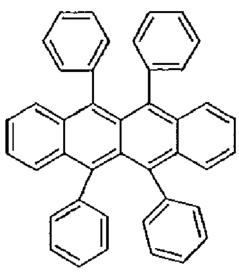
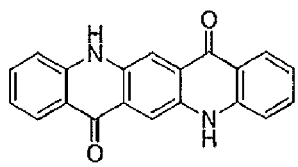
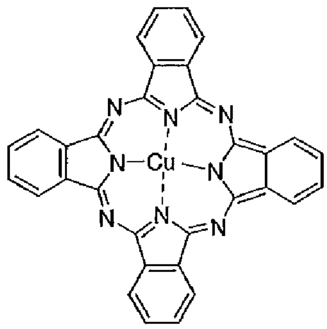

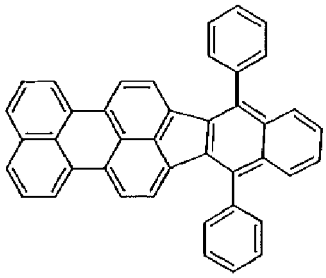
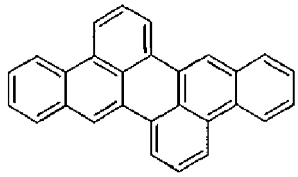

<Design Method for Composition>

The design method for the composition of the present invention is a design method for a composition containing

a first organic compound, a second organic compound and a third organic compound, wherein the first organic compound, the second organic compound of a delayed fluorescent material and the third organic compound of a fluorescent material are selected so as to satisfy the above-mentioned requirements (a) to (d).

In the design method for the composition of the present invention, preferably, the first organic compound, the second organic compound and the third organic compound are selected so as to additionally satisfy the above-mentioned requirements (f) and (g), also preferably the compounds are selected so as to satisfy at least one of the above-mentioned requirements (h), (i) and (j), and more preferably so as to satisfy all the requirements (h1), (i1) and (j 1).

Specifically, in the design method for the composition of the present invention, the first organic compound, the second organic compound and the third organic compound are selected so as to satisfy the requirements (a) to (d), preferably so as to additionally satisfy the requirements (f) and (g), or to satisfy at least one of the requirements (h), (i) and (j), more preferably so as to additionally satisfy the requirements (f) and (g) and to satisfy at least one of the requirements (h), (i) and (j), and especially more preferably so as to additionally satisfy the requirements (f) and (g), and to satisfy all the requirements (h1), (i1) and (j 1).

Regarding the description of the requirements (a) to (d), (f) to (j), and (h1) to (j1), reference can be made to the description in the section of <Composition> given hereinabove.

As described above, the composition of organic compounds satisfying the requirements (a) to (d), preferably the composition of organic compounds satisfying the requirements (a) to d), and the requirements (f) to (j) and (h1) to (j1) exhibits light emission with an extremely high efficiency and a high color purity, and can provide a high color purity especially in a wavelength range of less than 480 nm. The requirements (a) to (d), (f) to (j), and (h1) to (j1) are objective indices expressed by the magnitude correlation of numerical values, and therefore can clearly discriminate as to whether or not the composition can satisfy the requirements. Consequently, by selecting the first organic compound, the second organic compound and the third organic compound so as to satisfy the requirements (a) to (d), and the requirements (f) to (j), and (h1) to (j1), the composition having the above-mentioned properties can be surely realized.

Here, for the population to be selected for the first organic compound, the second organic compound and the third organic compound, the compound group exemplified in the section of [First Organic Compound], [Second Organic Compound] and [Third Organic Compound] given hereinabove can be used. However, the selection objects for use in the design method of the present invention should not be limitatively interpreted by these compound examples.

<Program>

The program of the present invention is a program for implementing the design method for the composition of the present invention.

Regarding the description of the design method for the composition of the present invention, reference can be made to the description in the section of <Design Method for Composition> given hereinabove.

The program of the present invention has a step of selecting a combination of the first organic compound, the second organic compound and the third organic compound to satisfy the requirements (a) to (d), for example, with reference to the data base that stores $E_{S1}(1)$ of the compound group usable as the first organic compound, the data base that stores $E_{S1}(2)$, $\lambda^{E}_{EM}(2)$ and $\lambda^{P}_{EM}(2)$ of the compound group usable as the second organic compound, and the data base that stores $E_{S1}(3)$, $\lambda^{P}_{AB}(3)$ and $\lambda^{P}_{EM}(3)$ of the compound group usable as the third organic compound.

Preferably, the data base of the second organic compound also stores LUMO(2) and HOMO(2) of the compound group, and the data base of the third organic compound also stores LUMO(3) and HOMO(3) of the compound group, and in the above step, with reference to these data, a combination of the first organic compound, the second organic compound and the third organic compound satisfying the requirements (a) to (d), and in addition thereto, also satisfying the requirements (f) and (g) is selected.

Also preferably, the program of the present invention has a step of calculating at least one of $R_0(2\text{-}3)$, $r(2\text{-}3)$ and $k_{FRET}(2\text{-}3)$ in the combination of the second organic compound and the third organic compound selected in the above step, and a step of selecting at least one of the requirements (h) to (j) from the combination.

An implementing protocol for the program of the present invention is described with reference to Fig. 1. In one preferred embodiment of the program, as shown in Fig. 1, first at least one combination of the first organic compound, the second organic compound and the third organic compound is estimated (S1), and whether or not the combination satisfies the requirements (a) to (d) is determined (S2). Subsequently, in the case where any other combination is desired to be determined, more than one cycle of the step S1 and the step S2 is repeated (S3). The determination results can be shown on a display or can be outputted by printing. The determination results can be outputted in every cycle of the step S1 and the step S2, or can be collectively outputted after the finish of all cycles. In the step S3, whether or not the cycle is further repeated can be determined by a sub-program. For example, a sub-program that gives a direction to repeat the cycle until a specific number of combinations satisfying all the requirements (a) to (d) can be found out can be employed. In the case where the cycle is repeated once or more, a combination different from the combination estimated previously is newly estimated in the step S1. At that time, any one of the first organic compound, the second

organic compound and the third organic compound can be changed, or any two can be changed, or all the three can be changed. The first organic compound, the second organic compound and the third organic compound that can be candidates are read in advance, and a sub-program for sequentially outputting the combinations of the candidate compounds can be used in the step S1. In addition, modifications apparent to those skilled in the art can be appropriately made.

## Examples

The features of the present invention will be described more specifically with reference to Examples and Comparative Examples given below. The materials, amounts used, proportions, contents of treatment and processing procedures, and the like shown in the following Examples can be appropriately modified unless they deviate from the substance of the invention. Accordingly, the scope of the invention is not construed as being limited to the specific examples shown below. Hereinunder the light emission characteristics were evaluated using an absorption spectrometer (UV-2550 by Shimadzu Corporation), and an absolute PL quantum yield measuring apparatus (by Hamamatsu Photonics K.K.). Optical computation was performed with an optical computation software program (setfos, by FLUXiM Corporation), using the refractive index of the material, the emission efficiency of the light emitting material actually measured with an integrating sphere and the data of the PL spectrum actually measured.

Compounds used in the following Examples and Comparative Examples are shown below. In Examples, Compound H1 shown in the column of the host material corresponds to the first organic compound, Compound DF1 or DF2 shown in the column of the delayed fluorescent material corresponds to the second organic compound, and Compound F 1 shown in the column of the fluorescent material corresponds to the third organic compound.

Host Material

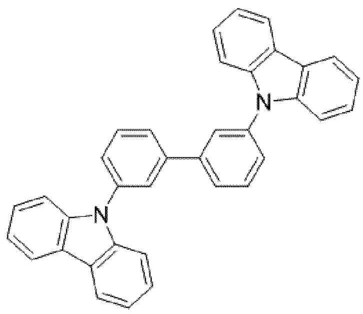

Compound H1 (mCBP)

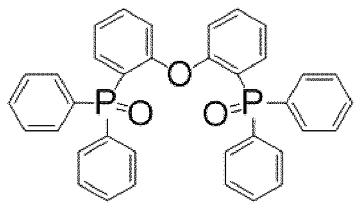

Compound H2

Delayed Fluorescent Material

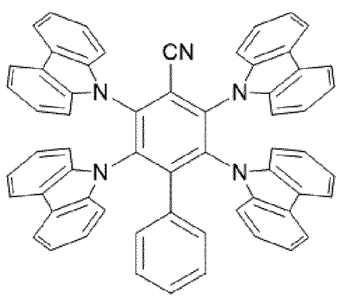

Compound DF1

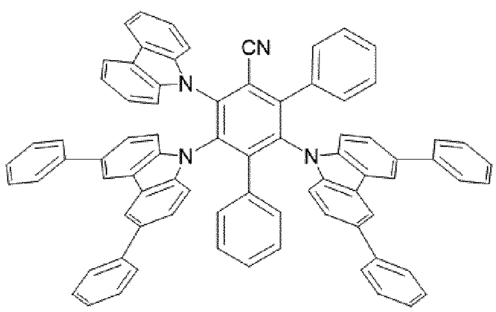

Compound DF2

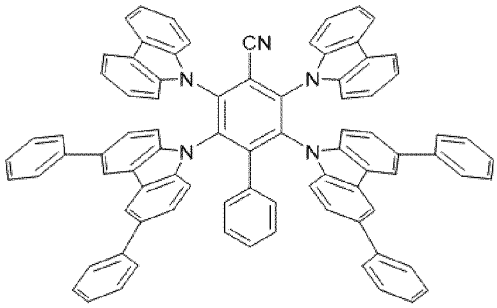

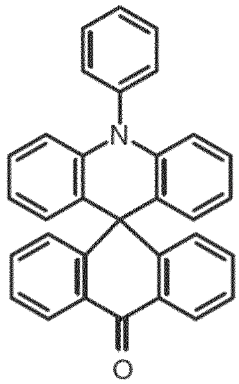

Compound DF3 Compound DF4

Fluorescent Material

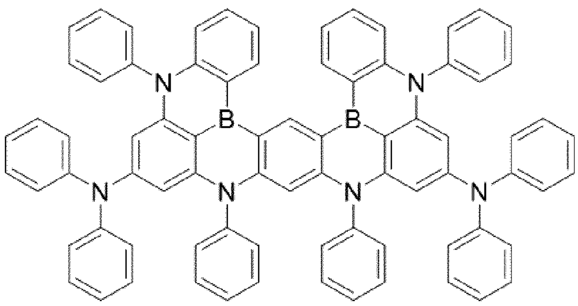

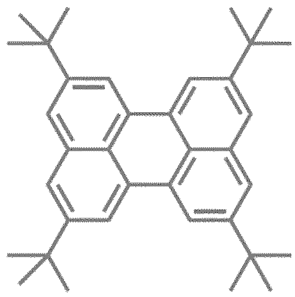

Compound F1 Compound F2

Physical data of the compounds used in Examples and Comparative Examples are shown in Tables 1 to 3.

[Table 1]

| Kind of Material | Compound No. | $E_{S1}(1)$ (eV) |
|---|---|---|
| Host Material | Compound H1 | 3.63 |
| | Compound H2 | 3.50 |

[Table 2]

| Kind of Material | Compound No. | $E_{S1}(2)$ (eV) | $\lambda^E_{EM}(2)$ (eV) | $\lambda^P_{EM}(2)$ (eV) | LUMO(2) (eV) | HOMO(2) (eV) |
|---|---|---|---|---|---|---|
| Delayed Fluorescent Material | Compound DF1 | 2.83 | 436 | 482 | -3.17 | -5.95 |
| | Compound DF2 | 2.83 | 436 | 477 | -3.30 | -6.12 |
| | Compound DF3 | 2.78 | 447 | 494 | -3.28 | -6.01 |
| | Compound DF4 | 2.88 | 430 | 486 | -2.7 | -5.8 |

Table 3

| Kind of Material | Compound No. | $E_{S1}(3)$ (eV) | $\lambda^P_{AB}(3)$ (eV) | $\lambda^P_{EM}(3)$ (eV) | LUMO(3) (eV) | HOMO(3) (eV) |
|---|---|---|---|---|---|---|
| Fluorescent Material | Compound F1 | 2.75 | 457 | 470 | -2.82 | -5.42 |
| | Compound F2 | 2.82 | 440 | 460 | -2.6 | -5.3 |

Constituent components of the compositions used in Examples and Comparative Examples are shown in Table 4. As shown in Table 4, the composition 1 and the composition 2 are compositions satisfying all the requirements (a) to (d) and the requirements (f) to (j) defined in the present invention. On the other hand, the comparative composition 1 does not satisfy the requirement (b), in which $\lambda^E_{EM}(2)$ (= 447 nm) is the same as $\lambda^P_{AB}(3)$ - 10 nm (= 447 nm), and does not also satisfy the requirements (h) to (j). The comparative composition 2 does not satisfy the requirement (b), in which $\lambda^E_{EM}(2)$ (= 430 nm) is the same as $\lambda^P_{AB}(3)$ - 10 nm (= 430 nm), and does not also satisfy the requirements (h) to (j).

[Table 4]

| Composition No. | Host Material (first organic compound) | Delayed Fluorescent Material (second organic compound) | Fluorescent Material (third organic compound) | Host Material/Delayed Fluorescent Material/ Fluorescent Material (by weight) | Foerster Radius $R_0$ (2-3) (nm) | Intermolecular Distance r(2-3) (nm) | $k_{FRET}$ (2-3) ($s^{-1}$) | Prompt Speed (ns) |
|---|---|---|---|---|---|---|---|---|
| Composition 1 | Compound H1 | Compound DF1 | Compound F1 | 69/30/1.0 | 7.3 | 3.71 | $6.1\times10^9$ | 10.1 |
| Composition 2 | Compound H1 | Compound DF2 | Compound F1 | 69/30/1.0 | 7.4 | 3.86 | $3.6\times10^9$ | 13.8 |
| Comparative Composition 1 | Compound H1 | Compound DF3 | Compound F1 | 69/30/1.0 | 6.5 | 3.91 | $1.5\times10^9$ | 14.1 |
| Comparative Composition 2 | Compound H2 | Compound DF4 | Compound F2 | 84/15/1.0 | 4.4 | 28.9 | $1.2\times10^9$ | 10.0 |

[1] Production and Evaluation of Thin Film

(Example 1) Production of thin film of composition 1

According to a vacuum evaporation method, under the condition of a vacuum degree of $1\times10^{-6}$ Pa, the compound H1, the compound DF1 and the compound F1 were deposited on a quartz substrate from different evaporation source to form a thin film having a thickness of 40 nm (composition 1). At that time, the composition ratio of the constituent compounds (compound H1/compound DF1/compound F1) was 69/30/1.0 (by weight).

(Example 2) Production of thin film of composition 2

A thin film (composition 2) was formed in the same manner as in Example 1, except that the compound DF2 was used in place of the compound DF1.

(Comparative Example 1) Production of thin film of comparative composition 1

A thin film (comparative composition 1) was formed in the same manner as in Example 1, except that the compound DF3 was used in place of the compound DF1.

(Comparative Example 2) Production of thin film of comparative composition 2

A thin film (comparative composition 2) was formed in the same manner as in Example 1, except that the compound H2 was used in place of the compound H1, the compound DF4 was used in place of the compound DF1, and the compound F2 was used in place of the compound F1.

Fig. 2 shows the emission spectra, measured with 365-nm excitation light, of the thin films produced in Examples 1 and 2 and Comparative Example 1. Table 5 shows the measurement results of the emission maximum wavelength, the photoluminescence quantum yield (PLQY), $FW_{0.3M}$ and the CIE chromaticity coordinates.

[Table 5]

| Example No. | Composition No. | PLQY (%) | $FW_{0.3M}$ (nm) | CIE | |
|---|---|---|---|---|---|
| | | | | x | y |
| Example 1 | Composition 1 | 80 | 32.0 | 0.127 | 0.195 |
| Example 2 | Composition 2 | 93 | 29.0 | 0.116 | 0.167 |
| Comparative Example 1 | Comparative Composition 1 | 83 | 54.5 | 0.159 | 0.319 |

As shown in Table 5, the light emission observed with the thin films of the composition 1 and the composition 2 had $FW_{0.3M}$ of less than 40 nm and a small value y of the chromaticity coordinates, and exhibited a high color purity. As opposed to these, the light emission from the comparative composition 1 not satisfying the requirement (b) had a broad peak shape, $FW_{0.3M}$ thereof was 54.5 nm and broad, and the color purity was low.

The emission spectrum, measured with a 365-nm excitation light of the thin film of the comparative composition 2 not satisfying the requirement (b) had a broad peak shape with a broadened skirt.

From these, it is known that the composition of three kinds of organic compounds satisfying the requirements (a) to (d) can significantly improve the color purity as compared with the composition not satisfying the requirement (b).

[2] Production and Evaluation of Organic Electroluminescent Device

In the following Examples 3 to 5 and Comparative Examples 3 and 4, bottom-emission type organic electroluminescent devices having a laminate structure shown in Fig. 3 were produced.

(Example 3) Production of organic electroluminescent device using composition 1 as light emitting layer

On a glass substrate 1 having, as formed thereon, an anode 2 of indium-tin oxide (ITO) having a thickness of 50 nm, thin films were laminated according to a vacuum evaporation method at a vacuum degree of $1\times10^{-6}$ Pa. First, on ITO, HATCN was deposited in a thickness of 10 nm to form a hole injection layer 3. Subsequently, α-NPD was deposited in a thickness of 35 nm to form a first hole transport layer 4. On that, TrisPCz was deposited in a thickness

of 10 nm to form a second hole transport layer 5. Further, mCBP was deposited in a thickness of 5 nm to form an electron blocking layer 6. Next, a light emitting layer of the composition 1 was formed. Specifically, the compound H1, the compound DF1 and the compound F1 were co-deposited from different evaporation sources to form a layer having a thickness of 40 nm to be a light emitting layer 7. At that time, the composition ratio of the compounds (compound H1/compound DF1/compound F1) was 69/30/1.0 (by weight). Next, the compound a was deposited in a thickness of 10 nm to form a hole blocking layer 8, and on that, the compound a and Liq were co-deposited from different evaporation sources in a thickness of 30 nm to form a hole transport layer 9. At that time, the composition ratio of the compounds (compound a/Liq) was 70/30 (by weight). Subsequently, Liq was deposited in a thickness of 2 nm to form an electron injection layer 10, and on that, Al was deposited in a thickness of 100 nm to form a cathode 11. Through the process, an organic electroluminescent device (EL device 1) using the composition 1 as the light emitting layer was produced.

(Examples 4, 5) Production of organic electroluminescent device by varying the composition ratio of the light emitting layer

An organic electroluminescent device (EL device 2) was produced in the same manner as in Example 3, except that the composition ratio of the light emitting layer (compound H1/compound DF1/compound F1) was changed to 69.5/30/0.5 (by weight).

Separately, an organic electroluminescent device (EL device 3) was produced in the same manner as in Example 3, except that the composition ratio of the light emitting layer (compound H1/compound DF1/compound F1) was changed to 68/30/2.0 (by weight).

(Comparative Example 3) Production of organic electroluminescent device not containing compound F1 in light emitting layer

An organic electroluminescent device (comparative EL device 1) was produced in the same manner as in Example 3, except that the compound F1 was not used and the light emitting layer was formed in a composition ratio, compound H1/compound DF1, of 70/30 (by weight).

(Comparative Example 4) Production of organic electroluminescent device using comparative composition 1 as light emitting layer

An organic electroluminescent device (comparative EL device 2) was produced in the same manner as in Example 3, except that the comparative composition 1 was used in place of the composition 1 to form the light emitting layer.

[Evaluation by actual measurement of organic electroluminescent device]

Emission spectra of the EL devices produced in Examples 3 to 5 and Comparative Example 3 are shown in Fig. 4. In Fig. 4, the numerical value in the parenthesis is the concentration of the compound F1 in the light emitting layer. Measured at 1000 cd/m$^2$, the driving voltage, the external quantum efficiency (EQE), the CIE chromaticity coordinates and the peak top wavelength of emission (emission maximum wavelength) of the EL devices produced in Examples 3 to 5 and Comparative Examples 3 and 4 are shown in Table 6.

Table 6]

| Device No. | Composition of Light Emitting Layer (by weight) | Driving Voltage (V) | EQE (%) | CIE | | Peak Top Wavelength of emission (nm) |
|---|---|---|---|---|---|---|
| | | | | x | y | |
| EL Device 2 | Compound H1/Compound DF1/Compound F1 = 69.5/30/0.5 | 4.39 | 17.6 | 0.13 | 0.16 | 470 |
| EL Device 1 | Compound H1/Compound DF1/Compound F 1= 69/30/1. 0 (composition 1) | 4.48 | 17.4 | 0.13 | 0.15 | 471 |
| EL Device 3 | Compound H1/Compound DF1/Compound F1 = 68/30/2.0 | 4.61 | 16.0 | 0.13 | 0.15 | 471 |
| Comparative EL Device 1 | Compound H1/Compound DF 1= 70/30 | 4.11 | 15.4 | 0.16 | 0.29 | 479 |

(continued)

| Device No. | Composition of Light Emitting Layer (by weight) | Driving Voltage (V) | EQE (%) | CIE | | Peak Top Wavelength of emission (nm) |
|---|---|---|---|---|---|---|
| | | | | x | y | |
| Comparative EL Device 2 | Compound H1/Compound DF3/Compound F1= 69.5/30/0.5 (comparative composition 1) | 4.85 | 17.8 | 0.15 | 0.24 | 472 |

As shown in Fig. 4, the peak width of the emission peak of the EL devices 1 to 3 is obviously narrow as compared with that of the emission peak of comparative EL device 1. As shown in Table 6, the EL devices 1 to 3 have a higher external quantum efficiency than the comparative EL device 1, and has a smaller value y of the chromaticity coordinates and therefore has a higher color purity than the comparative EL devices 1 and 2.

From these, it is known that the devices having a light emitting layer formed of three kinds of organic compounds satisfying the requirements (a) to (d) have an increased efficiency and an increased color purity than the device not using the third organic compound, and have an increased color purity than the device using three kinds of organic compounds but not satisfying the requirement (b).

[Evaluation by computation of organic electroluminescent device]

The bottom-emission type EL device 1 produced in Example 3, the EL device 4 using the composition 2 as the light emitting layer in place of the composition 1 in EL device 1, and the bottom-emission type comparative EL device 2 produced in Comparative Example 4 were evaluated for the device characteristics by computational optical simulation. In addition, the top-emission type EL device 5 using the composition 1 as the light emitting layer, the top-emission type EL device 6 using the composition 2 as the light emitting layer, and the top-emission type comparative EL device 3 using the comparative composition 1 as the light emitting layer were evaluated for the device characteristics by computational optical simulation. The results are shown in Table 7.

The top-emission type EL devices (EL devices 5 and 6, comparative EL device 3) are top-emission type organic electroluminescent devices having the following layers laminated on a glass substrate. In the following layer configuration, "/" indicates a boundary between the layers, and the numerical value in the parenthesis is the thickness of each layer. "APC reflection layer" is an alloy layer having a composition of Ag: 98% by weight, Pd: 1% by weight and Cu: 1% by weight, and the APC reflection layer faces the glass substrate. "Composition" is a composition constituting the light emitting layer, and is the composition 1 in the EL device 5, the composition 2 in the EL device 6, and the comparative composition 1 in the comparative EL device 3.

APC reflection layer (150 nm)/ITO anode (10 nm)/hole injection layer of HATCN (10 nm)/first hole transport layer of $\alpha$-NPD (35 nm)/ second hole transport layer of TrisPCz (10 nm)/electron blocking layer of mCBP (5 nm)/ light emitting layer of composition (40 nm)/hole blocking layer of compound a (10 nm)/electron transport layer of compound a (70 wt%):Liq (30 wt%) (30 nm)/electron injection layer of Liq (2 nm)/MgAg cathode (15 nm)/$\alpha$-NPD (105 nm)

[Table 7]

| Device No. | Device Structure | Composition of Light Emitting Layer | Spectral Radiance | Current Efficiency (cd/A) | CIE | |
|---|---|---|---|---|---|---|
| | | | | | x | y |
| EL Device 1 | bottom-emission type | Composition 1 | 0.65 | 31.4 | 0.120 | 0.192 |
| EL Device 4 | bottom-emission type | Composition 2 | 0.75 | 30.7 | 0.112 | 0.167 |
| Comparative EL Device 2 | bottom-emission type | Comparative Composition 1 | 0.50 | 48.9 | 0.141 | 0.306 |
| EL Device 5 | top-emission type | Composition 1 | 1.34 | 20.3 | 0.111 | 0.095 |

(continued)

| Device No. | Device Structure | Composition of Light Emitting Layer | Spectral Radiance | Current Efficiency (cd/A) | CIE | |
|---|---|---|---|---|---|---|
| | | | | | x | y |
| EL Device 6 | top-emission type | Composition 2 | 1.75 | 23.2 | 0.113 | 0.090 |
| Comparative EL Device 3 | top-emission type | Comparative Composition 1 | 1.04 | 18.3 | 0.103 | 0.122 |

As shown in Table 7, the EL device 1 using the composition 1 and the EL device 4 using the composition 2 have a higher color purity (having a smaller value y in the chromaticity coordinates) than the comparative EL device 2 using the comparative composition 1; and the EL device 5 using the composition 1 and the EL device 6 using the composition 2 have a higher color purity (having a smaller value y in the chromaticity coordinates) than the comparative EL device 3 using the comparative composition 1. In particular, the top-emission type EL devices 5 and 6 have a significantly increased emission intensity than the top-emission type comparative EL device 3. From these, it is known that, when the light emitting layer is formed using three kinds of organic compounds satisfying the requirements (a) to (d), the color purity improves as compared with the case not satisfying the requirement (b), and especially in a top-emission type device, the emission intensity greatly improves.

The materials used in the others than the light emitting layer in the organic electroluminescent devices are shown below.

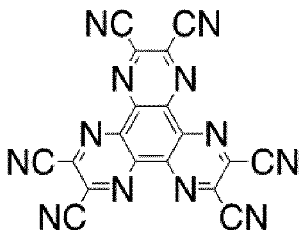

HAT-CN

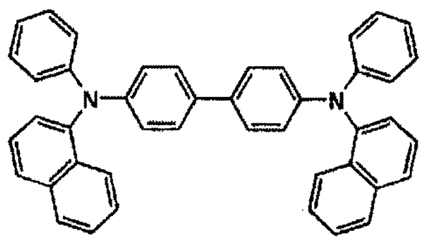

α−NPD

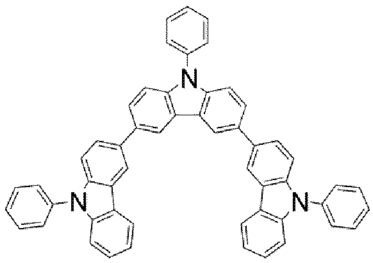

Tris-PCz

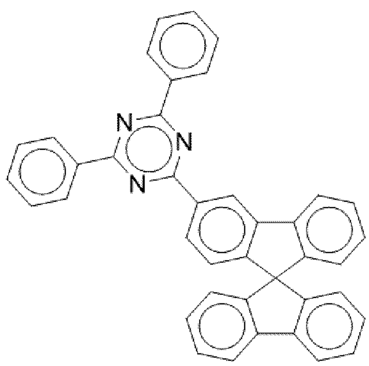

化合物a

Compound a

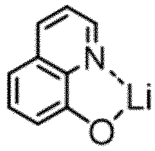

Liq

Industrial Applicability

The composition of the present invention is a composition that emits by a TAF mechanism, and exhibits light emission with a high efficiency and a high color purity. Consequently, using the composition of the present invention, a TAF-type organic light emitting device having a high efficiency and a high color purity can be readily realized. Consequently, the industrial applicability of the present invention is great.

Reference Signs List

1 Glass Substrate
2 Anode
3 Hole Injection Layer
4 First Hole Transport Layer
5 Second Hole Transport Layer
6 Electron Blocking Layer
7 Light Emitting Layer
8 Hole Blocking Layer
9 Hole Transport Layer
10 Cathode

**Claims**

**1.** A composition containing a first organic compound, a second organic compound of a delayed fluorescent material and a third organic compound of a fluorescent material satisfying the following requirements (a) to (d),

Requirement (a) $$E_{S1}(1) > E_{S1}(2) > E_{S1}(3)$$

Requirement (b) $$\lambda^{E}_{EM}(2) < \lambda^{P}_{AB}(3) - 10\ \text{nm}$$

Requirement (c) $$\lambda^{P}_{EM}(3) < \lambda^{P}_{EM}(2)$$

Requirement (d) $$\lambda^{P}_{EM}(3) < 480\ \text{nm}$$

wherein:

$E_{S1}(1)$ represents the lowest excited singlet energy of the first organic compound,
$E_{S1}(2)$ represents the lowest excited singlet energy of the second organic compound,
$E_{S1}(3)$ represents the lowest excited singlet energy of the third organic compound,
$\lambda^{E}_{EM}(2)$ represents the emission wavelength (unit nm) on the short wavelength side of the second organic compound,
$\lambda^{P}_{AB}(3)$ represents the wavelength (unit nm) of the peak top on the longest wavelength side of the absorption spectrum of the third organic compound,

$\lambda^{P}_{EM}(2)$ represents the wavelength of the peak top of the emission spectrum of the second organic compound, and
$\lambda^{P}_{EM}(3)$ represents the wavelength of the peak top of the emission spectrum of the third organic compound.

**2.** The composition according to claim 1, satisfying the following requirement (e),

$$\text{Requirement (e)} \qquad FW_{0.3M} < 40\ \text{nm}$$

wherein $FW_{0.3M}$ represents the spectral width in which the relative intensity to the emission peak of the emission spectrum of the composition is 30%.

**3.** The composition according to claim 2, satisfying the following requirement (e1),

$$\text{Requirement (e1)} \qquad FW_{0.3M} < 32\ \text{nm}$$

**4.** The composition according to any one of claims 1 to 3, satisfying the following requirements (f) and (g),

$$\text{Requirement (f)} \qquad \text{LUMO}(2) \leq \text{LUMO}(3)$$

$$\text{Requirement (g)} \qquad \text{HOMO}(2) \leq \text{HOMO}(3)$$

wherein:

LUMO(2) represents the LUMO energy of the second organic compound,
LUMO(3) represents the LUMO energy of the third organic compound,
HOMO(2) represents the HOMO energy of the second organic compound, and
HOMO(3) represents the HOMO energy of the third organic compound.

**5.** The composition according to any one of claims 1 to 4, satisfying the following requirement (h),

$$\text{Requirement (h)} \qquad R_0(2\text{-}3) > 6.5\ \text{nm}$$

wherein $R_0$(2-3) represents the Foerster radius between the second organic compound and the third organic compound.

**6.** The composition according to any one of claims 1 to 5, satisfying the following requirement (i),

$$\text{Requirement (i)} \qquad r(2\text{-}3) < 3.91\ \text{nm}$$

wherein r(2-3) represents the intermolecular distance between the second organic compound and the third organic compound.

**7.** The composition according to any one of claims 1 to 6, satisfying the following requirement (j),

$$\text{Requirement (j)} \qquad k_{FRET}(2\text{-}3) > 1.5\times10^{9}\ \text{s}^{-1}$$

wherein $k_{FRET}$(2-3) represents the Foerster energy transfer speed constant between the second organic compound and the third organic compound.

**8.** The composition according to any one of claims 1 to 4, satisfying the following requirements (h1)), (i1) and (j 1),

Requirement (h1) $R_0(2\text{-}3) \geq 7.3$ nm

Requirement (i1) $r(2\text{-}3) \leq 3.71$ nm

Requirement (j1) $k_{FRET}(2\text{-}3) \geq 6.1\times10^9$ $s^{-1}$

wherein:

$R_0$(2-3) represents the Foerster radius between the second organic compound and the third organic compound,
r(2-3) represents the intermolecular distance between the second organic compound and the third organic compound, and
$k_{FRET}$(2-3) represents the Foerster energy transfer speed constant between the second organic compound and the third organic compound.

**9.** The composition according to any one of claims 1 to 8, wherein the second organic compound has a structure represented by the following general formula (1),

General Formula (1)

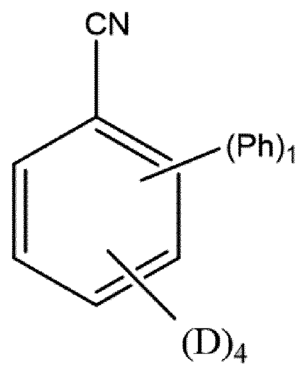

wherein D represents a substituted or unsubstituted carbazol-9-yl group, and Ph represents a phenyl group optionally substituted with at least one group selected from the group consisting of an alkyl group, an aryl group and a group of these groups linking together.

**10.** The composition according to claim 9, wherein the second organic compound has a structure represented by the following general formula (1a),

General Formula (1a)

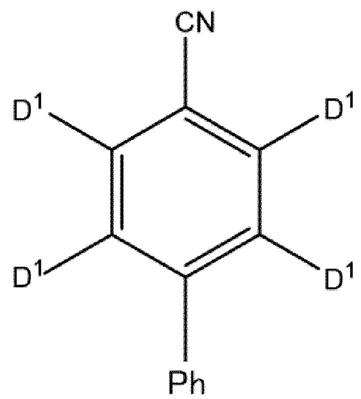

wherein $D^1$ represents a substituted or unsubstituted carbazol-9-yl group, and Ph represents a phenyl group optionally substituted with at least one group selected from the group consisting of an alkyl group, an aryl group and a group of these groups linking together.

**11.** The composition according to any one of claims 1 to 8, wherein the second organic compound has a structure represented by the following general formula (2),

General Formula (2)

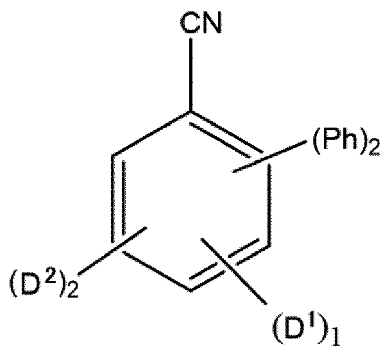

wherein $D^1$ represents a substituted or unsubstituted carbazol-9-yl group, $D^2$ represents a substituted or unsubstituted carbazol-9-yl group that differs from $D^1$, and two Ph's each independently represent a phenyl group optionally substituted with at least one group selected from the group consisting of an alkyl group, an aryl group and a group of these groups linking together.

**12.** The composition according to claim 11, wherein the second organic compound has a structure represented by the following general formula (2a),

General Formula (2a)

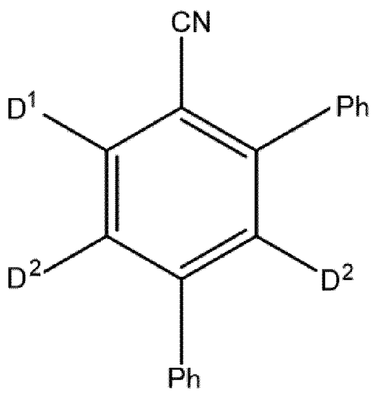

wherein $D^1$ represents a substituted or unsubstituted carbazol-9-yl group, $D^2$ represents a substituted or unsubstituted carbazol-9-yl group that differs from $D^1$, and two Ph's each independently represent a phenyl group optionally substituted with at least one group selected from the group consisting of an alkyl group, an aryl group and a group of these groups linking together.

**13.** The composition according to any one of claims 9 to 12, wherein D, $D^1$ and $D^2$ each independently have a structure represented by any of the following D1 to D37,

D1
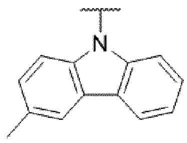
D2
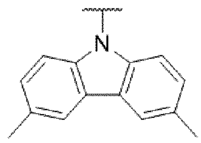
D3
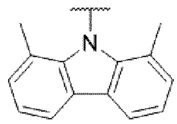
D4
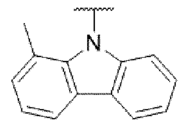

D5
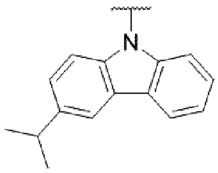
D6
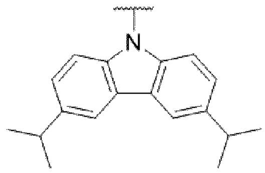
D7
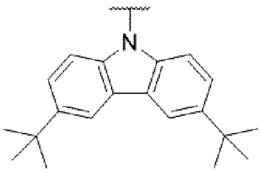
D8
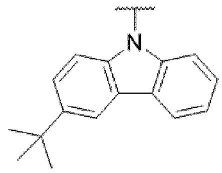

D9
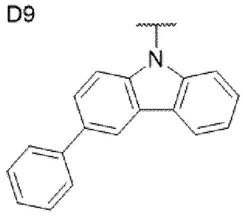
D10
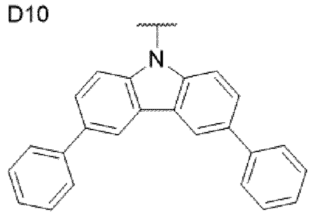
D11
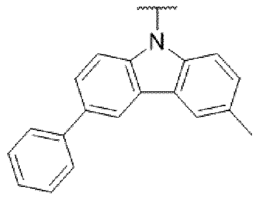
D12
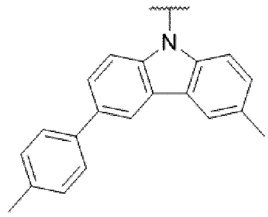

D13
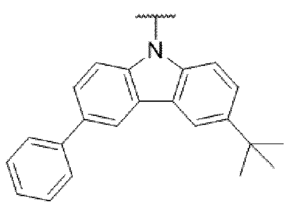
D14
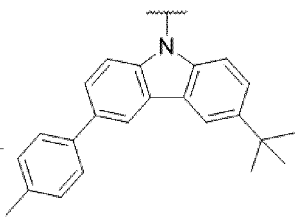
D15
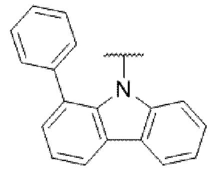
D16
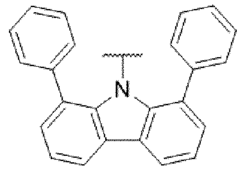

D17
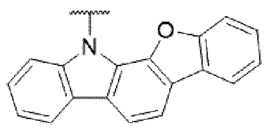
D18
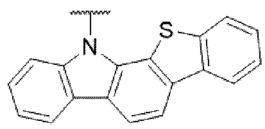
D19
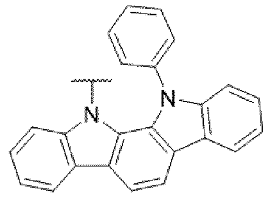
D20
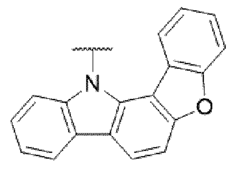

D21
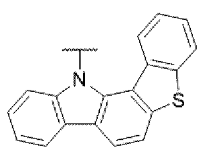
D22
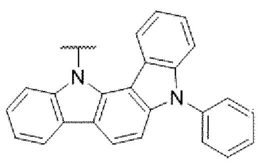
D23
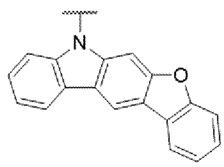
D24
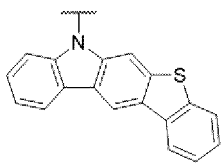

D25

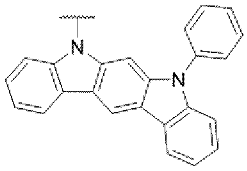

D26

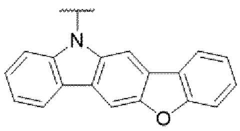

D27

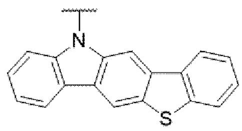

D28

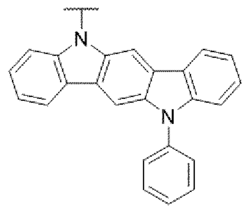

D29

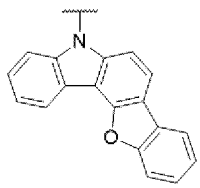

D30

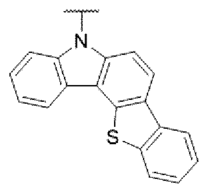

D31

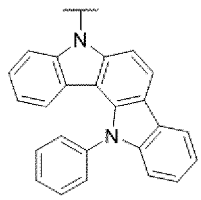

D32

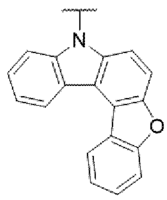

D33

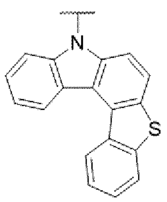

D34

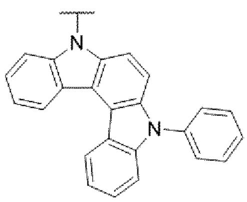

D35

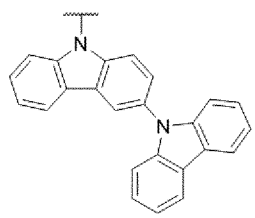

D36

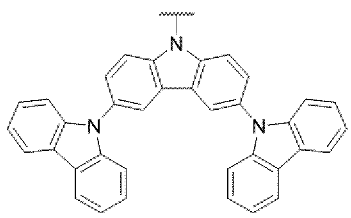

D37

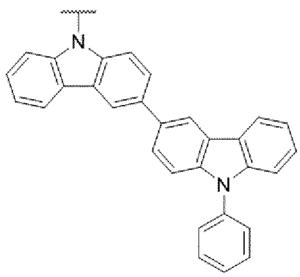

**14.** Use of the composition of any one of claims 1 to 13 as a light emitting composition.

**15.** A film containing a light emitting composition of the composition of any one of claims 1 to 13.

**16.** Use of the film of claim 15 as a light emitting film.

**17.** An organic electroluminescent device having an anode, a cathode, and at least one organic layer containing a light emitting layer between the anode and the cathode, wherein:

the light emitting layer contains the composition of any one of claims 1 to 13, and
the maximum component of light emission from the device is fluorescence from the third organic compound.

**18.** The organic electroluminescent device according to claim 17, which is a top-emission type.

**19.** A design method for a composition containing a first organic compound, a second organic compound and a third organic compound, wherein the first organic compound, the second organic compound of a delayed fluorescent material and the third organic compound of a fluorescent material are selected so as to satisfy the following require-

ments (a) to (d),

$$\text{Requirement (a)} \qquad E_{S1}(1) > E_{S1}(2) > E_{S1}(3)$$

$$\text{Requirement (b)} \qquad \lambda^{E}_{EM}(2) < \lambda^{P}_{AB}(3) \text{ -10 nm}$$

$$\text{Requirement (c)} \qquad \lambda^{P}_{EM}(3) < \lambda^{P}_{EM}(2)$$

$$\text{Requirement (d)} \qquad \lambda^{P}_{EM}(3) < 480 \text{ nm}$$

wherein:

$E_{S1}(1)$ represents the lowest excited singlet energy of the first organic compound,
$E_{S1}(2)$ represents the lowest excited singlet energy of the second organic compound,
$E_{S1}(3)$ represents the lowest excited singlet energy of the third organic compound,
$\lambda^{E}_{EM}(2)$ represents the emission wavelength (unit nm) on the short wavelength side of the second organic compound,
$\lambda^{P}_{AB}(3)$ represents the wavelength (unit nm) of the peak top on the longest wavelength side of the absorption spectrum of the third organic compound,
$\lambda^{P}_{EM}(2)$ represents the wavelength of the peak top of the emission spectrum of the second organic compound, and
$\lambda^{P}_{EM}(3)$ represents the wavelength of the peak top of the emission spectrum of the third organic compound.

**20.** The design method for a composition according to claim 19, wherein the compounds are selected so as to additionally satisfy the following requirements (f) and (g),

$$\text{Requirement (f)} \qquad \text{LUMO}(2) \leq \text{LUMO}(3)$$

$$\text{Requirement (g)} \qquad \text{HOMO}(2) \leq \text{HOMO}(3)$$

wherein:

LUMO(2) represents the LUMO energy of the second organic compound,
LUMO(3) represents the LUMO energy of the third organic compound,
HOMO(2) represents the HOMO energy of the second organic compound, and
HOMO(3) represents the HOMO energy of the third organic compound.

**21.** The design method for a composition according to claim 19 or 20, wherein the compounds are selected so as to additionally satisfy the following requirement (h),

$$\text{Requirement (h)} \qquad R_0(2\text{-}3) > 6.5 \text{ nm}$$

wherein $R_0(2\text{-}3)$ represents the Foerster radius between the second organic compound and the third organic compound.

**22.** The design method for a composition according to any one of claims 19 to 21, wherein the compounds are selected so as to additionally satisfy the following requirement (i),

$$\text{Requirement (i)} \qquad r(2\text{-}3) < 3.91 \text{ nm}$$

wherein r(2-3) represents the intermolecular distance between the second organic compound and the third organic compound.

**23.** The design method for a composition according to any one of claims 19 to 22, wherein the compounds are selected so as to additionally satisfy the following requirement (j),

$$\text{Requirement (j)} \qquad k_{FRET}(2\text{-}3) > 1.5\times10^{9}\ s^{-1}$$

wherein $k_{FRET}$(2-3) represents the Foerster energy transfer speed constant between the second organic compound and the third organic compound.

**24.** The design method for a composition according to claim 19, wherein the compounds are selected so as to additionally satisfy the following requirements (h1), (i1) and (j 1),

$$\text{Requirement (h1)} \qquad R_0(2\text{-}3) \geq 7.3\ nm$$

$$\text{Requirement (i1)} \qquad r(2\text{-}3) \leq 3.71\ nm$$

$$\text{Requirement (j1)} \qquad k_{FRET}(2\text{-}3) \geq 6.1\times10^{9}\ s^{-1}$$

wherein:

$R_0$(2-3) represents the Foerster radius between the second organic compound and the third organic compound,
r(2-3) represents the intermolecular distance between the second organic compound and the third organic compound, and
$k_{FRET}$(2-3) represents the Foerster energy transfer speed constant between the second organic compound and the third organic compound.

**25.** A program for implementing the design method for a composition of any one of claims 19 to 24.

FIG. 1

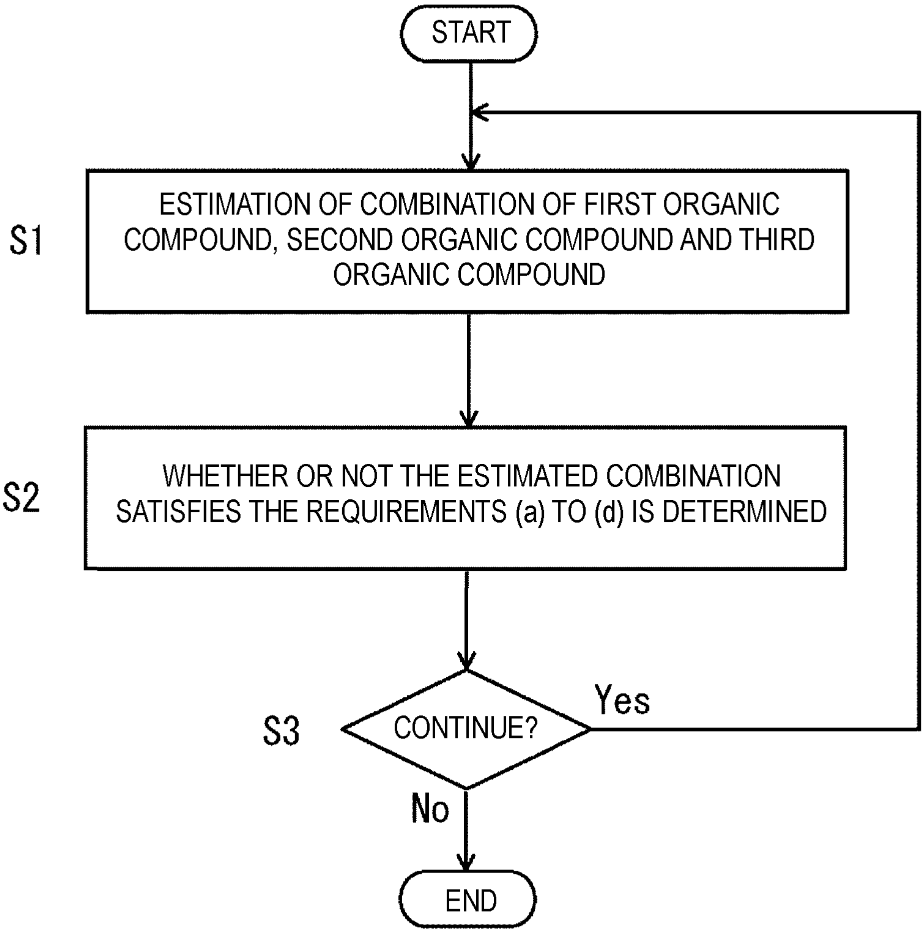
START
S1
ESTIMATION OF COMBINATION OF FIRST ORGANIC COMPOUND, SECOND ORGANIC COMPOUND AND THIRD ORGANIC COMPOUND
S2
WHETHER OR NOT THE ESTIMATED COMBINATION SATISFIES THE REQUIREMENTS (a) TO (d) IS DETERMINED
S3
CONTINUE?
Yes
No
END

FIG. 2

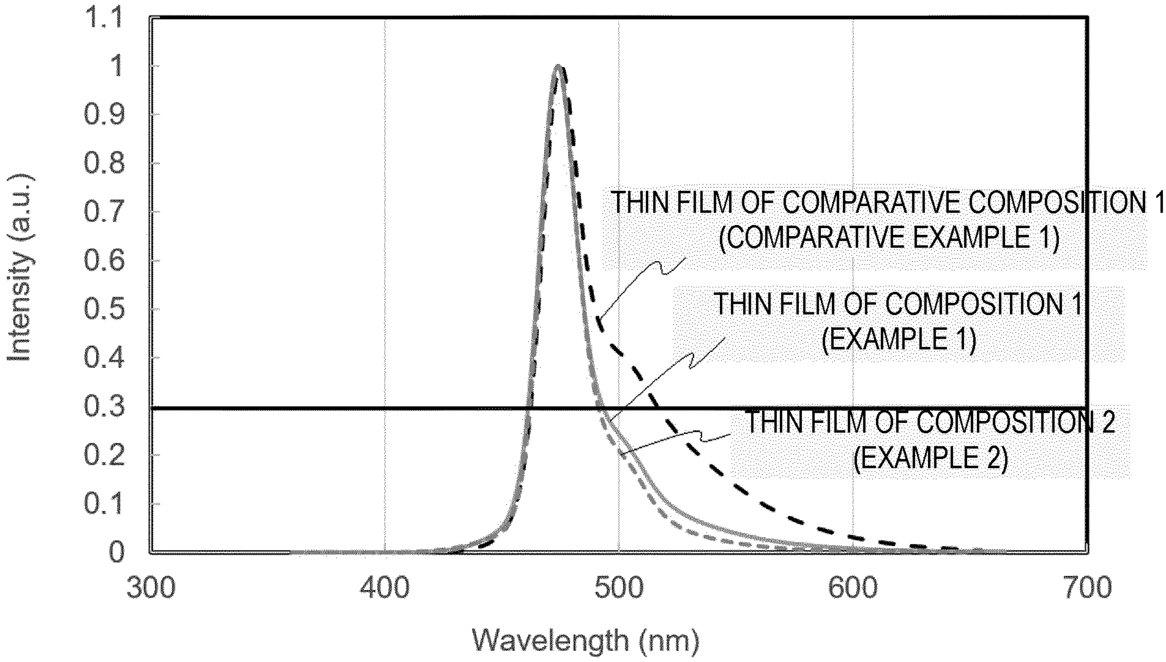
Intensity (a.u.)
1.1
1
0.9
0.8
0.7
0.6
0.5
0.4
0.3
0.2
0.1
0
300
400
500
600
700
Wavelength (nm)
THIN FILM OF COMPARATIVE COMPOSITION 1 (COMPARATIVE EXAMPLE 1)
THIN FILM OF COMPOSITION 1 (EXAMPLE 1)
THIN FILM OF COMPOSITION 2 (EXAMPLE 2)

FIG. 3

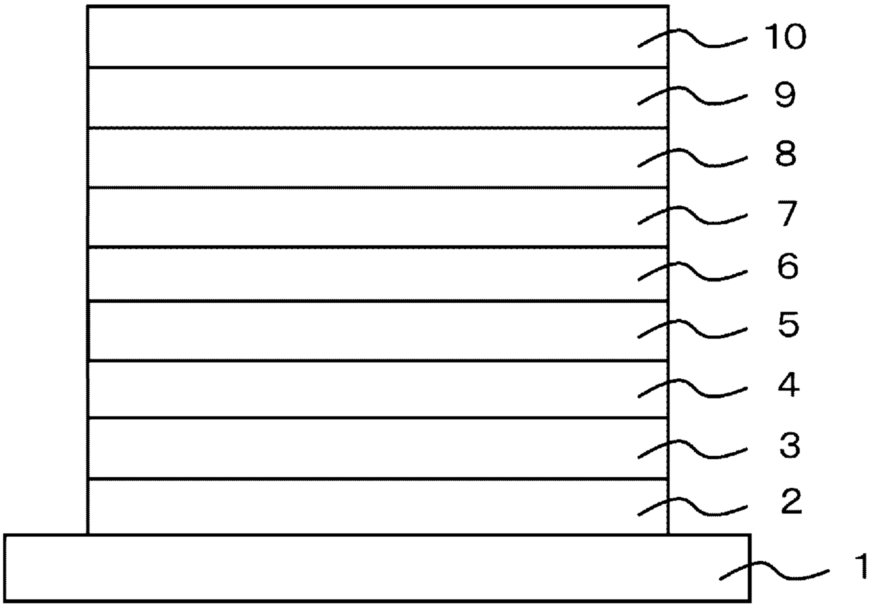
10
9
8
7
6
5
4
3
2
1

FIG. 4

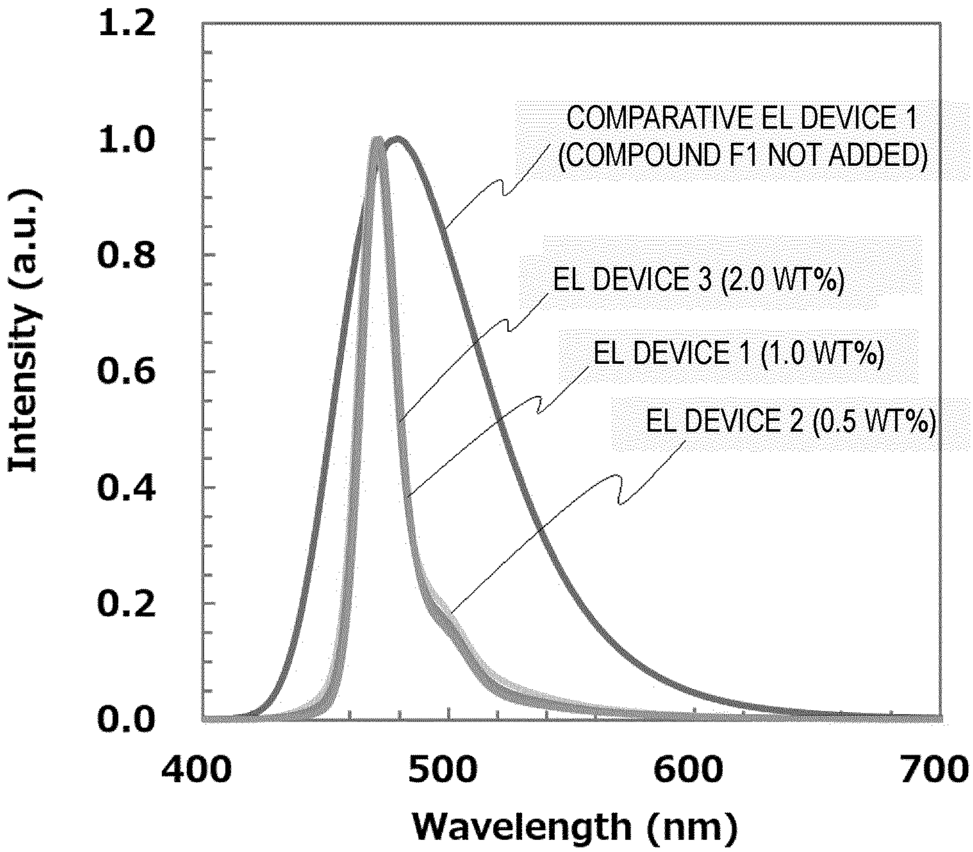
1.2
1.0
0.8
0.6
0.4
0.2
0.0
Intensity (a.u.)
400
500
600
700
Wavelength (nm)
COMPARATIVE EL DEVICE 1 (COMPOUND F1 NOT ADDED)
EL DEVICE 3 (2.0 WT%)
EL DEVICE 1 (1.0 WT%)
EL DEVICE 2 (0.5 WT%)

## INTERNATIONAL SEARCH REPORT

International application No.
**PCT/JP2022/011169**

**A. CLASSIFICATION OF SUBJECT MATTER**

***H01L 51/50***(2006.01)i; ***C09K 11/06***(2006.01)i; ***H05B 33/10***(2006.01)i
FI: H05B33/14 B; H05B33/10; C09K11/06 690; C09K11/06 610; C09K11/06 630

According to International Patent Classification (IPC) or to both national classification and IPC

**B. FIELDS SEARCHED**

Minimum documentation searched (classification system followed by classification symbols)

H01L51/50; C09K11/06; H05B33/10

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | WO 2020/039930 A1 (KYUSHU UNIVERSITY, KWANSEI GAKUIN UNIVERSITY, KYULUX INC.) 27 February 2020 (2020-02-27) paragraphs [0011], [0032], [0033], [0044]-[0050], [0056], [0066], [0067], [0095]-[0119] | 1-25 |
| A | JP 2020-31162 A (KYUSHU UNIVERSITY, KYULUX INC.) 27 February 2020 (2020-02-27) paragraphs [0019], [0025], [0102], [0202]-[0208] | 1-25 |
| A | WO 2020/067143 A1 (KYOTO UNIVERSITY) 02 April 2020 (2020-04-02) paragraph [0008] | 1-25 |
| A | WO 2019/009307 A1 (MITSUBISHI CHEMICAL CORP.) 10 January 2019 (2019-01-10) paragraph [0027] | 1-25 |

☐ Further documents are listed in the continuation of Box C.  ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **18 May 2022** | **31 May 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | <br>Telephone No. |

Form PCT/ISA/210 (second sheet) (January 2015)

**INTERNATIONAL SEARCH REPORT**
**Information on patent family members**

International application No.
**PCT/JP2022/011169**

| Patent document cited in search report | Publication date (day/month/year) | Patent family member(s) | Publication date (day/month/year) |
|---|---|---|---|
| WO 2020/039930 A1 | 27 February 2020 | US 2021/0202851 A1<br>paragraphs [0016], [0047], [0048], [0064]-[0074], [0084], [0095], [0108]-[0162]<br>EP 3843168 A1<br>CN 112585778 A<br>KR 10-2021-0055712 A | |
| JP 2020-31162 A | 27 February 2020 | US 2021/0202864 A1<br>paragraphs [0031], [0033], [0160], [0368]-[0378]<br>WO 2020/039708 A1<br>EP 3843167 A1<br>CN 112602206 A<br>KR 10-2021-0043688 A | |
| WO 2020/067143 A1 | 02 April 2020 | CN 112771031 A<br>KR 10-2021-0065956 A | |
| WO 2019/009307 A1 | 10 January 2019 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2020039930 A
- US 20200168814 A1